# EUROPEAN PATENT APPLICATION

(11) **EP 4 131 230 A1**
(43) Date of publication of application: **08.02.2023**
(21) Application number: 22186618.9
(22) Date of filing: 25.07.2022
(51) Int. Cl.: G09G 3/20, G09G 3/3208, G09G 3/36, G09G 3/00, H01L 27/32, H01L 51/52, G06F 3/041

(54) **DISPLAY DEVICE INCLUDING SENSOR ELECTRODES**

(30) Priority: 02.08.2021 KR 20210101348
(71) Applicant: Samsung Display Co., Ltd., Yongin-si, Gyeonggi-do 17113 (KR)
(72) Inventor: CHOI, Sang Hyun, Gangnam-gu, Seoul (KR); Kim, Hyoeng Ki, Yeontong-gu, Suwon-si, Gyeonggi-do (KR); LEE, Hoon Gi, Yeongtong-gu, Suwon-si, Gyeonggi-do (KR); CHOI, Chaun Gi, 103-1002 Yeongtong-gu, Suwon-si, Gyeonggi-do (KR)
(74) Representative: Dr. Weitzel & Partner

(57) **Abstract**

A display device includes a substrate which includes a main area, a first auxiliary area extending from a first side of the main area in a first direction, and a sub-area extending from a second side of the main area in a second direction intersecting the first direction. Scan lines are disposed in the main area and the first auxiliary area and extend in the first direction. Data lines are disposed in the main area and the first auxiliary area and extend in the second direction. Sensor lines are disposed in the main area and the first auxiliary area and extend in the first direction. Sensor electrodes are disposed in the main area and the first auxiliary area and are connected to the sensor lines, respectively.

## Description

### TECHNICAL FIELD

The present disclosure relates to a display device and, more specifically, to a display device including sensor electrodes.

### DISCUSSION OF THE RELATED ART

Display devices are being applied to various electronic devices such as smartphones, digital cameras, computer monitors, notebook computers, navigation devices, and smart televisions.

Display devices may be flat panel display devices such as liquid crystal display (LCD) devices, field emission display devices, or light emitting display devices. The light emitting display devices include organic light emitting display devices including organic light emitting elements (such as organic light emitting diodes OLEDs), inorganic light emitting display devices including inorganic light emitting elements such as inorganic semiconductors, and micro-light emitting display devices including micro-light emitting elements.

While display devices have traditionally been rigid, light emitting display device including a flexible substrate can be bent, folded, rolled, and/or stretched without sustaining damage such as cracking.

### SUMMARY

A display device according to an embodiment of the present invention includes a substrate which includes a main area, a first auxiliary area extending from a first side of the main area in a first direction, and a sub-area extending from a second side of the main area in a second direction intersecting the first direction. Scan lines are disposed in the main area and the first auxiliary area and extend in the first direction. Data lines are disposed in the main area and the first auxiliary area and extend in the second direction. Sensor lines are disposed in the main area and the first auxiliary area and extend in the first direction. Sensor electrodes are disposed in the main area and the first auxiliary area and are connected to the sensor lines, respectively.

The display device may further include a first scan driver disposed on a first edge of the first auxiliary area and connected to the scan lines, a first sensor distribution circuit disposed on the first edge of the first auxiliary area and connected to the sensor lines, and a data distribution circuit disposed on a second edge of the main area and a second edge of the first auxiliary area and connected to the data lines.

The display device may further include sensor fan-out lines connected to the first sensor distribution circuit and disposed on the second edge of the main area, the second edge of the first auxiliary area, and the sub-area.

The number of the sensor fan-out lines may be smaller than the number of the sensor lines.

The first sensor distribution circuit may include a sensor distribution transistor which connects the sensor lines and the sensor fan-out lines in an N:1 ratio, where N is an integer of 2 or greater.

The display device may further include data fan-out lines connected to the data distribution circuit and disposed on the second edge of the main area, the second edge of the first auxiliary area, and the sub-area.

The number of the data fan-out lines may be smaller than the number of the data lines.

The data distribution circuit may connect the data lines and the data fan-out lines in an M:1 ratio, where M is an integer of 2 or greater.

The display device may further include pixels which are disposed in the main area and the first auxiliary area and each includes a plurality of emission units. The sensor lines do not overlap the emission units, that is in a plan view the sensor lines are positioned completely outside of the emission units.

Each of the pixels may include a first emission unit emitting light of a first color, a second emission unit emitting light of a second color and disposed on a side of the first emission unit in the first direction, and a third emission unit emitting light of a third color and disposed on a side of the first emission unit in the second direction intersecting the first direction and a side of the second emission unit in the second direction.

One of the sensor lines may be disposed between the first emission unit and the third emission unit and between the second emission unit and the third emission unit.

The display device may further include a dam disposed between the first scan driver and the first sensor distribution circuit. The sensor lines at least partially overlap the dam and are connected to the sensor distribution transistor.

The display device may further include a dam disposed outside of the first sensor distribution circuit. That is, the dam may be disposed on a side of the first sensor distribution circuit which is located away from the main display area. The sensor lines at least partially overlap the dam.

The display device may further include a sensor connection line connected to one of the sensor lines. The sensor connection line at least partially overlaps the dam and is connected to the sensor distribution transistor.

The first auxiliary area may be bent and may have a particular curvature, a part of the first auxiliary area is disposed under the main area, the sub-area is bent and may have a particular curvature, a part of the sub-area is disposed under the main area, and the particular curvature of the first auxiliary area is smaller than the particular curvature of the sub-area.

The display device may further include a first roller at least partially surrounded by at least a part of the first auxiliary area of the substrate. The position of a first bending area of the first auxiliary area is moved in the first direction by the movement of the first roller, and the first auxiliary area at least partially overlaps the main area in a first state and does not overlap the main area in a second state, that is, is free of an overlap with the main area in a second state.

A display device according to a further embodiment includes a substrate including a main area, a first auxiliary area extending from a first side of the main area in a first direction, and a sub-area extending from a second side of the main area in a second direction intersecting the first direction. A first roller is at least partially surrounded by at least a part of the first auxiliary area of the substrate. The position of a first bending area of the first auxiliary area is moved in the first direction by the movement of the first roller. The first auxiliary area overlaps the main area in a first state and does not overlap the main area in a second state, that is, is free of an overlap with the main area in a second state.

The position of the first bending area may be closer to the main area in the second state than in the first state.

The first bending area may be adjacent to the main area in the second state.

The display device may further include scan lines disposed in the main area and the first auxiliary area and extended in the first direction. Data are disposed in the main area and the first auxiliary area and extend in the second direction. Sensor lines are disposed in the main area and the first auxiliary area and extend in the first direction. Sensor electrodes are disposed in the main area and the first auxiliary area and are connected to the sensor lines, respectively.

A display device according to a further embodiment includes a substrate, an active layer of a thin-film transistor disposed on the substrate. A gate insulating layer is disposed on the active layer of the thin-film transistor. A scan line and a first gate electrode are disposed on the gate insulating layer. A first interlayer insulating film is disposed on the first gate electrode. A capacitor electrode is disposed on the first interlayer insulating film. A second interlayer insulating film is disposed on the capacitor electrode. Data lines are disposed on the second interlayer insulating film. A first planarization layer is disposed on the data lines. A power line is disposed on the first planarization layer. A second planarization layer is disposed on the power line. Sensor fan-out lines are disposed on the second planarization layer. A third planarization layer is disposed on the sensor fan-out lines. A pixel electrode is disposed on the third planarization layer. A light emitting layer is disposed on the pixel electrode. A common electrode is disposed on the light emitting layer. An encapsulation layer is disposed on the common electrode. A sensor electrode and sensor lines are disposed on the encapsulation layer. N sensor lines among the sensor lines are electrically connected to one of the sensor fan-out lines, where N is a positive integer of 2 or greater.

The display device may further include a first data fan-out line which is disposed on the gate insulating layer, a second data fan-out line which is disposed on the first interlayer insulating film, and a third data fan-out line which is disposed on the second interlayer insulating film.

M data lines among the data lines may be electrically connected to one of the first data fan-out line, the second data fan-out line, and the third data fan-out line, where M is a positive integer of 2 or greater.

The third data fan-out line may at least partially overlap the first data fan-out line and the second data fan-out line, and the first data fan-out line and the second data fan-out line do not overlap each other, that is in a plan view the first data fan-out line are positioned completely outside of the second data fan-out line.

A display device according to a further embodiment includes a substrate, an active layer of a thin-film transistor disposed on the substrate. A gate insulating layer is disposed on the active layer of the thin-film transistor. A scan line and a first gate electrode are disposed on the gate insulating layer. A first interlayer insulating film is disposed on the first gate electrode. A capacitor electrode is disposed on the first interlayer insulating film. A second interlayer insulating film is disposed on the capacitor electrode. A second gate electrode is disposed on the second interlayer insulating film. A third interlayer insulating film is disposed on the second gate electrode. Data lines are disposed on the third interlayer insulating film. A first planarization layer is disposed on the data lines. Sensor fan-out lines are disposed on the first planarization layer. A second planarization layer is disposed on the sensor fan-out lines. A pixel electrode is disposed on the second planarization layer. A light emitting layer is disposed on the pixel electrode. A common electrode is disposed on the light emitting layer. An encapsulation layer is disposed on the common electrode. A sensor electrode and sensor lines are disposed on the encapsulation layer. N sensor lines among the sensor lines are electrically connected to one of the sensor fan-out lines, where N is a positive integer of 2 or greater.

### BRIEF DESCRIPTION OF THE DRAWINGS

The above and other features of the present disclosure will become more apparent by describing in detail embodiments thereof, with reference to the accompanying drawings, in which:
FIGS. 1 and 2 are perspective views of a display device according to an embodiment of the present disclosure;
FIGS. 3 and 4 are side views of the display device according to an embodiment of the present disclosure;
FIGS. 5 and 6 are perspective views of a display device according to an embodiment of the present disclosure;
FIGS. 7 and 8 are side views of a display device according to an embodiment of the present disclosure;
FIG. 9 is a cross-sectional view illustrating a stacked structure of a display device according to an embodiment of the present disclosure;
FIG. 10 is a plan view illustrating a layout of scan lines, data lines, a first scan driver, a second scan driver, data distribution circuits, a first sensor distribution circuit, and a second sensor distribution circuit of a display layer of a display panel according to an embodiment of the present disclosure;
FIG. 11 is a plan view illustrating a layout of sensor electrodes and sensor lines of a touch sensing layer of a display panel according to an embodiment of the present disclosure;
FIG. 12 is a plan view illustrating a layout of sensor electrodes, sensing lines, and pixels according to an embodiment of the present disclosure;
FIG. 13 is a cross-sectional view of an example of a display panel taken along line A-A' of FIG. 12;
FIG. 14 is a circuit diagram of a first data distribution circuit according to an embodiment of the present disclosure;
FIG. 15 is a plan view illustrating an example of a layout of data distribution transistors connected to a first data fan-out line, a second data fan-out line, and a third data fan-out line of FIG. 14;
FIG. 16 is a cross-sectional view of an example of the display panel taken along lines B-B', E-E', F-F', and H-H' of FIG. 15;
FIG. 17 is a circuit diagram of a first sensor distribution circuit according to an embodiment of the present disclosure;
FIG. 18 is a plan view illustrating a layout of an example of sensor distribution transistors connected to a first sensor fan-out line and a second sensor fan-out line of FIG. 17;
FIG. 19 is a cross-sectional view of an example of the display panel taken along line I-I' of FIG. 18;
FIG. 20 is a cross-sectional view of an example of the display panel taken along line A-A' of FIG. 12;
FIG. 21 is a cross-sectional view of an example of the display panel taken along lines B-B', E-E', F-F', and H-H' of FIG. 15;
FIG. 22 is a cross-sectional view of an example of the display panel taken along line I-I' of FIG. 18;
FIG. 23 is a plan view illustrating a layout of scan lines, data lines, a first scan driver, a second scan driver, data distribution circuits, a first sensor distribution circuit, and a second sensor distribution circuit of a display layer of a display panel according to an embodiment of the present disclosure;
FIG. 24 is a plan view illustrating a layout of sensor electrodes and sensor lines of a touch sensing layer of the display panel according to an embodiment of the present disclosure;
FIG. 25 is a plan view illustrating a layout of an example of sensor distribution transistors connected to a first sensor fan-out line and a second sensor fan-out line of FIG. 24;
FIG. 26 is a cross-sectional view of an example of the display panel taken along line K-K' of FIG. 25; and
FIG. 27 is a cross-sectional view of an example of the display panel taken along line K-K' of FIG. 25.

### DETAILED DESCRIPTION

Embodiments of the present disclosure will be described more fully hereinafter with reference to the accompanying drawings. Like reference numerals may refer to like elements throughout the specification and the accompanying drawings.

Herein, when two or more elements or values are described as being substantially the same as or about equal to each other, it is to be understood that the elements or values are identical to each other, the elements or values are equal to each other within a measurement error, or if measurably unequal, are close enough in value to be functionally equal to each other as would be understood by a person having ordinary skill in the art. For example, the term "about" as used herein is inclusive of the stated value and means within an acceptable range of deviation for the particular value as determined by one of ordinary skill in the art, considering the measurement in question and the error associated with measurement of the particular quantity (e.g., the limitations of the measurement system). For example, "about" may mean within one or more standard deviations as understood by one of the ordinary skill in the art. Further, it is to be understood that while parameters may be described herein as having "about" a certain value, according to exemplary embodiments of the present disclosure, the parameter may be exactly the certain value or approximately the certain value within a measurement error as would be understood by a person having ordinary skill in the art. Other uses of these terms and similar terms to describe the relationship between components should be interpreted in a like fashion.

It will be understood that when a component, such as a film, a region, a layer, or an element, is referred to as being "on", "connected to", "coupled to", or "adjacent to" another component, it can be directly on, connected, coupled, or adjacent to the other component, or intervening components may be present. It will also be understood that when a component is referred to as being "between" two components, it can be the only component between the two components, or one or more intervening components may also be present. It will also be understood that when a component is referred to as "covering" another component, it can be the only component covering the other component, or one or more intervening components may also be covering the other component. Other phrases use to describe the relationship between elements may be interpreted in a like fashion.

It will be further understood that descriptions of features or aspects within each embodiment are available for other similar features or aspects in other embodiments of the present disclosure, unless the context clearly indicates otherwise. Accordingly, all features and structures described herein may be mixed and matched in any desirable manner.

As used herein, the singular forms "a", "an" and "the" are intended to include the plural forms as well, unless the context clearly indicates otherwise.

Spatially relative terms, such as "below", "lower", "above", "upper", etc., may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" other elements or features would then be oriented "above" the other elements or features. Thus, the term "below" may encompass both an orientation of above and below.

When a feature is said to extend, protrude, or otherwise follow a certain direction, it will be understood that the feature may extend primarily in the stated direction, although it is to be understood that the feature extended to a lesser extent in various other directions as it is a three-dimensional structure. Moreover, extending in one direction may include extending on an opposite direction to the stated direction, i.e., the negative direction. Accordingly, the feature is not necessarily limited to follow exactly one direction, and may follow along an axis formed by the direction, unless the context clearly indicates otherwise.

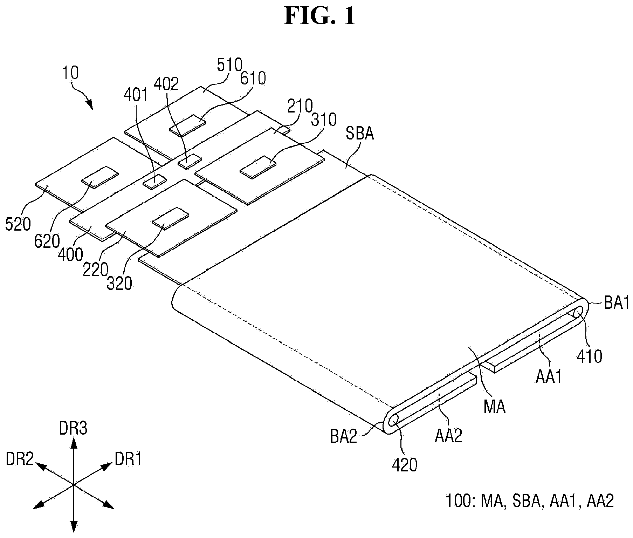

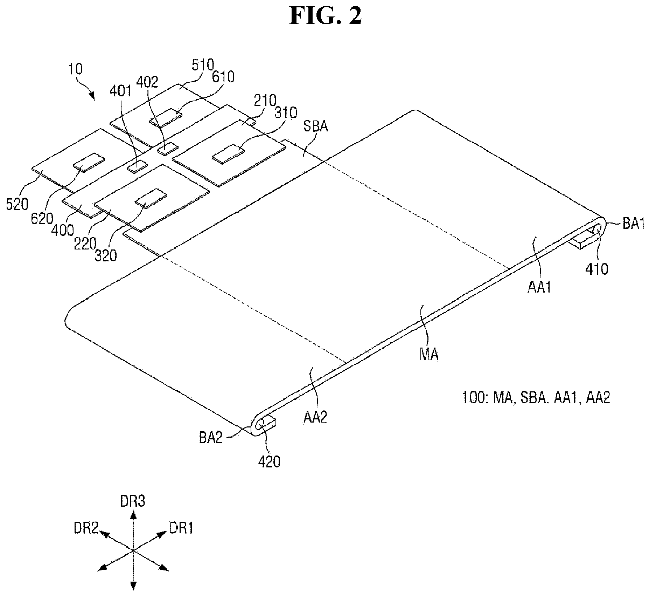

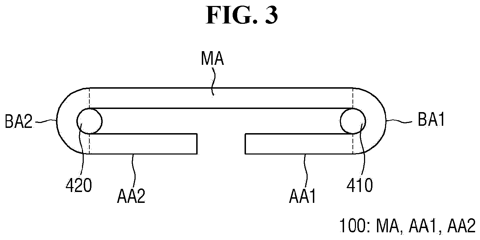

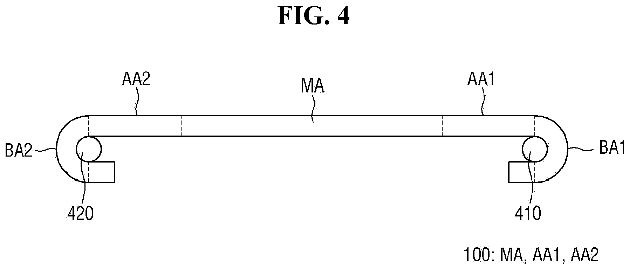

FIGS. 1 and 2 are perspective views of a display device 10 according to an embodiment of the present disclosure. FIGS. 3 and 4 are side views of the display device 10 according to an embodiment of the present disclosure. FIG. 1 is a perspective view illustrating a first state of the display device 10, and FIG. 2 is a perspective view illustrating a second state of the display device 10. FIG. 3 is a side view illustrating the first state of the display device 10, and FIG. 4 is a side view illustrating the second state of the display device 10.

Referring to FIGS. 1 through 4, the display device 10 may be applied to portable electronic devices such as mobile phones, smartphones, tablet personal computers (PCs), mobile communication terminals, electronic notebooks, electronic books (e.g., e-book readers), portable multimedia players (PMPs), navigation devices, and ultra-mobile PCs (UMPCs). Alternatively, the display device 10 may be applied as a display unit of a television, a notebook computer, a computer monitor, an electronic billboard, or an Internet of things (IoT) device. Alternatively, the display device 10 may be applied to wearable devices such as smart watches, watch phones, glass-like displays, and head-mounted displays (HMDs).

In addition, the display device 10 may be a light emitting display device such as an organic light emitting display device using organic light emitting diodes, a quantum dot light emitting display device including quantum dot light emitting layers, an inorganic light emitting display device including inorganic semiconductors, or a micro or nano light emitting display device using micro or nano light emitting diodes. A case where the display device 10 is an organic light emitting display device will be mainly described below, but the present disclosure is not necessarily limited thereto.

The display device 10 includes a display panel 100, a first source circuit board 210, a second source circuit board 220, a first source driving circuit 310, a second source driving circuit 320, a control circuit board 400, a timing control circuit 401, a first circuit board 510, a second circuit board 520, a first integrated circuit 610, and a second integrated circuit 620. In FIGS. 3 and 4, the first source circuit board 210, the second source circuit board 220, the first source driving circuit 310, the second source driving circuit 320, the control circuit board 400, the timing control circuit 401, the first circuit board 510, the second circuit board 520, the first integrated circuit 610, and the second integrated circuit 620 are omitted for ease of description, but may be understood to be present even if not depicted.

The display panel 100 may be a flexible display panel that is curved or bent by a first roller 410 and a second roller 420. The display panel 100 may include a main area MA, a sub-area SBA, a first auxiliary area AA1, and a second auxiliary area AA2.

In FIGS. 1 through 4, a first direction DR1 indicates a horizontal direction of the display panel 100, a second direction DR2 indicates a vertical direction of the display panel 100, and a third direction DR3 indicates a thickness direction of the display panel 100. In this case, "left," "right," "upper," and "lower" indicate directions when the display panel 100 is seen in a plan view. For example, a "right side" indicates one side in the first direction DR1, a "left side" indicates the other side in the first direction DR1, an "upper side" indicates one side in the second direction DR2, and a "lower side" indicates the other side in the second direction DR2. In addition, "top" indicates one side in the third direction DR3, and "bottom" indicates the other side in the third direction DR3.

The main area MA may be a flat area that is not curved or bent, but the present disclosure is not necessarily limited thereto. The main area MA may have a quadrilateral planar shape, but the present disclosure is not necessarily limited thereto. A length of the main area MA in the first direction DR1 may be greater than a length of the main area MA in the second direction DR2.

The sub-area SBA may be disposed on one side of the main area MA in the second direction DR2. For example, the sub-area SBA may extend from the main area MA in the second direction DR2.

The sub-area SBA may be an area that is curved or bent. The sub-area SBA may be bent with a particular degree of curvature. When the sub-area SBA is bent, it may at least partially overlap the main area MA in the third direction DR3. The sub-area SBA may have a quadrilateral planar shape, but the present disclosure is not necessarily limited thereto.

A length of the sub-area SBA in the first direction DR1 may be substantially the same as the length of the main area MA in the first direction DR1. Alternatively, the length of the sub-area SBA in the first direction DR1 may be smaller than the length of the main area MA in the first direction DR1. A length of the sub-area SBA in the second direction DR2 may be smaller than the length of the main area MA in the second direction DR2.

The first auxiliary area AA1 may be disposed on one side of the main area MA in the first direction DR1. For example, the first auxiliary area AA1 may extend from one side of the main area MA in the first direction DR1.

The second auxiliary area AA2 may be disposed on the other side of the main area MA in the first direction DR1. For example, the second auxiliary area AA2 may extend from the other side of the main area MA in the first direction DR1.

The first auxiliary area AA1 and the second auxiliary area AA2 may be areas that are curved or bent. The first auxiliary area AA1 may be curved or bent along the first roller 410. The second auxiliary area AA2 may be curved or bent along the second roller 420. Each of the first auxiliary area AA1 and the second auxiliary area AA2 may be bent with a particular degree of curvature. The curvature of the sub-area SBA may be smaller than the curvature of first auxiliary area AA1 and the second auxiliary area AA2.

A length of the first auxiliary area AA1 in the first direction DR1 and a length of the second auxiliary area AA2 in the first direction DR1 may each be smaller than the length of the main area MA in the first direction DR1. A length of the first auxiliary area AA1 in the second direction DR2 and a length of the second auxiliary area AA2 in the second direction DR2 may each be substantially the same as the length of the main area MA in the second direction DR2.

The first source circuit board 210 and the second source circuit board 220 may be attached to one edge of the sub-area SBA. One side of the sub-area SBA may be opposite the other side of the sub-area SBA which contacts the main area MA.

Each of the first source circuit board 210 and the second source circuit board 220 may be attached to pads disposed on the one edge of the sub-area SBA by using an anisotropic conductive film. Therefore, each of the first source circuit board 210 and the second source circuit board 220 may be electrically connected to a pad portion of the display panel 100. Each of the first source circuit board 210 and the second source circuit board 220 may be a flexible printed circuit board, a printed circuit board, or a flexible film such as a chip-on-film.

The first source driving circuit 310 and the second source driving circuit 320 may output data voltages to data lines of the display panel 100. For example, the first source driving circuit 310 may be connected to the data lines of the display panel 100 through the first source circuit board 210 and the pads of the sub-area SBA. In addition, the second source driving circuit 320 may be connected to the data lines of the display panel 100 through the second source circuit board 220 and the pads of the sub-area SBA.

Each of the first source driving circuit 310 and the second source driving circuit 320 may be formed as, or otherwise instantiated, an integrated circuit. The first source driving circuit 310 may be attached to a surface of the first source circuit board 210 using a chip-on-film (COF) method. The second source driving circuit 320 may be attached to a surface of the second source circuit board 220 using a COF method.

The control circuit board 400 may be electrically connected to the first source circuit board 210 and the second source circuit board 220. The control circuit board 400 may be attached to the first source circuit board 210 and the second source circuit board 220 using an anisotropic conductive film. The control circuit board 400 may be a printed circuit board.

The timing control circuit 401 may be formed as, or otherwise instantiated as, an integrated circuit. The timing control circuit 401 may be attached to a surface of the control circuit board 400.

The timing control circuit 401 may transmit digital video data to the first source driving circuit 310 and the second source driving circuit 320 and control driving timing of the first source driving circuit 310 and the second source driving circuit 320. For example, the timing control circuit 401 may transmit first digital video data and a first timing control signal to the first source driving circuit 310 and may transmit second digital video data and a second timing control signal to the second source driving circuit 320.

In addition, the timing control circuit 401 may be connected to power lines of the display panel 100 through the first source circuit board 210 or the second source circuit board 220 and the pads of the sub-area SBA.

A sensor control circuit 402 may be formed as, or otherwise instantiated as, an integrated circuit. The sensor control circuit 402 may be attached to the surface of the control circuit board 400. In this case, the sensor control circuit 402 may be electrically connected to sensor electrodes through the control circuit board 400, the first source circuit board 210 and the second source circuit board 220 through sensor fan-out lines and sensor lines of the display panel 100. Alternatively, the sensor control circuit 402 may be disposed on a surface of a separate flexible circuit board. In this case, an end of the flexible circuit board may be connected to the display panel 100. The sensor control circuit 402 may be electrically connected to the sensor electrodes through the flexible circuit board through the sensor fan-out lines and sensor lines of the display panel 100.

The sensor control circuit 402 transmits a sensor driving signal to the sensor electrodes and senses a change in self-capacitance of each of the sensor electrodes. The sensor control circuit 402 may determine whether a user's touch or proximity has occurred according to the change in the self-capacitance of each of the sensor electrodes. The user's touch indicates that an object such as a user's finger or a stylus/pen directly touches a surface of the display panel 100. The user's proximity indicates that an object such as a user's finger or a stylus/pen is positioned (e.g., hovers) above the surface of the display panel 100.

The first circuit board 510 and the second circuit board 520 may be electrically connected to the control circuit board 400. Each of the first circuit board 510 and the second circuit board 520 may be attached to the control circuit board 400 using an anisotropic conductive film. Each of the first circuit board 510 and the second circuit board 520 may be a flexible printed circuit board, a printed circuit board, or a flexible film such as a chip-on-film.

The first integrated circuit 610 may be attached to a surface of the first circuit board 510 using a COF method. The second integrated circuit 620 may be attached to a surface of the second circuit board 520 using a COF method. Therefore, each of the first integrated circuit 610 and the second integrated circuit 620 may be electrically connected to the timing control circuit 401. At least any one of the first integrated circuit 610 and the second integrated circuit 620 may transmit digital video data to the timing control circuit 401.

Each of the first roller 410 and the second roller 420 may extend in the second direction DR2. In addition, each of the first roller 410 and the second roller 420 may move in the first direction DR1. In addition, each of the first roller 410 and the second roller 420 may have a rotation axis in the second direction DR2 and may rotate in a first rotation direction or a second rotation direction. The first rotation direction may be a clockwise direction, and the second rotation direction may be a counterclockwise direction. For example, each of the first roller 410 and the second roller 420 may move in the first direction DR1 and may rotate in the first rotation direction or the second rotation direction.

A first bending area BA1 of the first auxiliary area AA1 may move in the first direction DR1 according to the movement and rotation of the first roller 410. A second bending area BA2 of the second auxiliary area AA2 may move in the first direction DR1 according to the movement and rotation of the second roller 420.

When the first roller 410 moves to the right and rotates in the second rotation direction, the first bending area BA1 of the first auxiliary area AA1 may move to the left and is straightened. Accordingly, a new section of the first auxiliary AA1 area which becomes the first bending area BA1 of the first auxiliary area AA1 may be disposed further away from the main area MA Therefore, the first auxiliary area AA1 seen from the front of the display device 10 may be widened.

When the second roller 420 moves to the left and rotates in the first rotation direction, the second bending area BA2 of the second auxiliary area AA2 may move to the right and is straightened. Accordingly, a new section of the second auxiliary AA2 area which becomes the second bending area BA2 of the second auxiliary area AA2 may be disposed further away from the main area MA Therefore, the second auxiliary area AA2 seen from the front of the display device 10 may be widened.

For example, when the first roller 410 moves to the right and rotates in the second rotation direction and the second roller 420 moves to the left and rotates in the first rotation direction, the display device 10 may switch from the first state to the second state.

In contrast, when the first roller 410 moves to the left and rotates in the first rotation direction, the first bending area BA1 of the first auxiliary area AA1 may move to the right or below the main area MA Accordingly, the first bending area BA1 of the first auxiliary area AA1 may be disposed closer adjacent to the main area MA. Therefore, the first auxiliary area AA1 seen from the front of the display device 10 may be narrowed.

When the second roller 420 moves to the right and rotates in the second rotation direction, the second bending area BA2 of the second auxiliary area AA2 may move to the left or below the main area MA Accordingly, the second bending area BA2 of the second auxiliary area AA2 may be disposed closer adjacent to the main area MA Therefore, the second auxiliary area AA2 seen from the front of the display device 10 may be narrowed.

For example, when the first roller 410 moves to the left and rotates in the first rotation direction and the second roller 420 moves to the right and rotates in the second rotation direction, the display device 10 may switch from the second state to the first state.

The first bending area BA1 of the first auxiliary area AA1 in the first state of the display device 10 may be disposed closer to the main area MA than the first bending area BA of the first auxiliary area AA1 in the second state of the display device 10. Therefore, in the second state of the display device 10, most of the first auxiliary area AA1 and the second auxiliary area AA2 may be visible from the front of the display device 10. In the first state of the display device 10, the first auxiliary area AA1 and the second auxiliary area AA2 may be hardly visible from the front of the display device 10. For example, in the first state of the display device 10, the first auxiliary area AA1 and the second auxiliary area AA2 may be visible at right and left edges of the display device 10.

A length of a front surface of the display panel 100 in the first direction DR1 in the second state of the display device 10 may be greater than a length of the front surface of the display panel 100 in the first direction DR1 in the first state of the display device 10. In addition, in the second state of the display device 10, the area of the first auxiliary area AA1 overlapping the main area MA in the third direction DR3 may be smaller than the area of the first auxiliary area AA1 not overlapping the main area MA in the third direction DR3. In contrast, in the first state of the display device 10, the area of the first auxiliary area AA1 overlapping the main area MA in the third direction DR3 may be larger than the area of the first auxiliary area AA1 not overlapping the main area MA in the third direction DR3. In addition, in the second state of the display device 10, the area of the second auxiliary area AA2 overlapping the main area MA in the third direction DR3 may be smaller than the area of the second auxiliary area AA2 not overlapping the main area MA in the third direction DR3. In contrast, in the first state of the display device 10, the area of the second auxiliary area AA2 overlapping the main area MA in the third direction DR3 may be larger than the area of the second auxiliary area AA2 not overlapping the main area MA in the third direction DR3.

The first auxiliary area AA1 is curved or bent according to the rotation of the first roller 410. Therefore, the curvature of the first roller 410 and the curvature of the first auxiliary area AA1 may be substantially the same. The second auxiliary area AA2 is curved or bent according to the rotation of the second roller 420. Therefore, the curvature of the second roller 420 and the curvature of the second auxiliary area AA2 may be substantially the same. In addition, the curvature of the first roller 410 and the curvature of the second roller 420 may be substantially the same. Therefore, the curvature of the first auxiliary area AA1 and the curvature of the second auxiliary area AA2 may be substantially the same. Further, to prevent the sub-area SBA from being interfered with by the first auxiliary area AA1 and the second auxiliary area AA2 when the sub-area SBA is bent, the curvature of the sub-area SBA may be different from the curvature of the first auxiliary area AA1 or the curvature of the second auxiliary area AA2. For example, the curvature of the sub-area SBA may be smaller than the curvature of the first auxiliary area AA1 and the curvature of the second auxiliary area AA2.

As illustrated in FIGS. 1 through 4, the first auxiliary area AA1 and the second auxiliary area AA2 slide according to the movement of the first roller 410 and the second roller 420. Accordingly, the size of the display panel 100 seen from the front of the display device 10, for example, the size of a display area in which an image is displayed may be adjusted. Therefore, a user can select the size of the display panel 100 by adjusting the display device 10 to the first state or the second state according to the intended use of the display device 10.

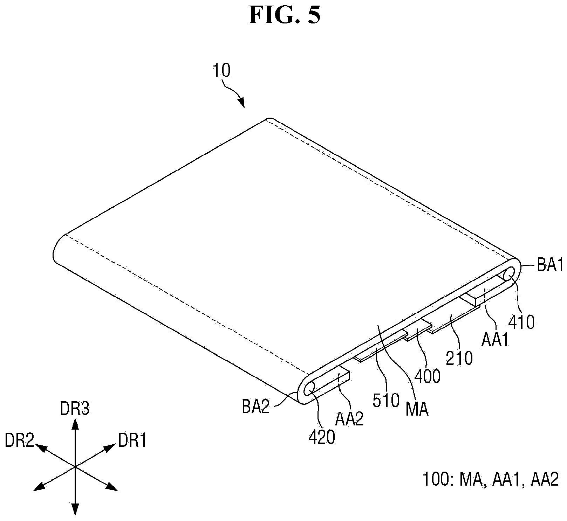

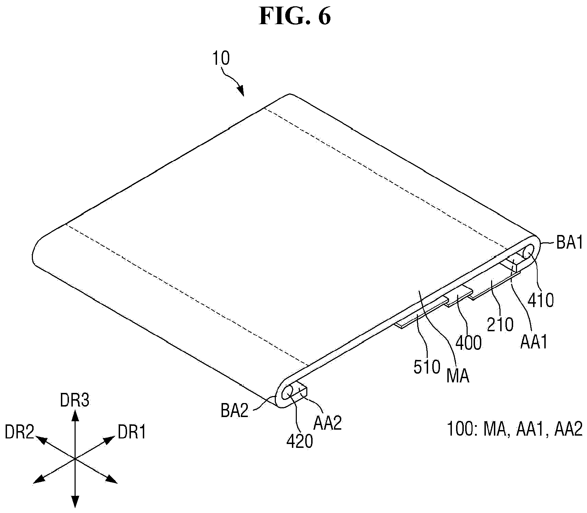

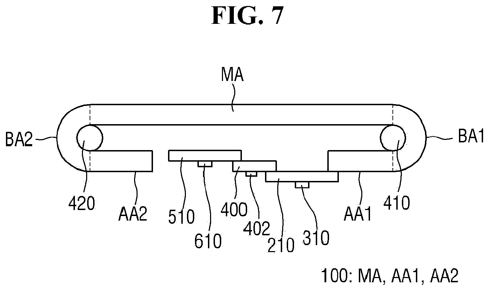

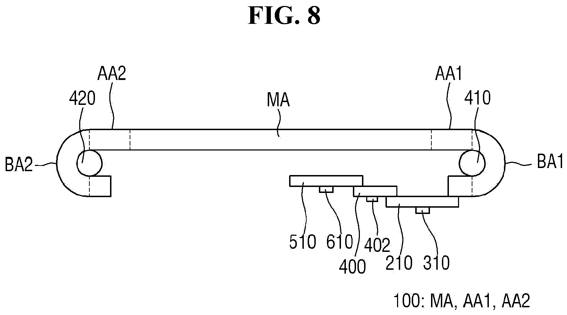

FIGS. 5 and 6 are perspective views of a display device 10 according to an embodiment of the present disclosure. FIGS. 7 and 8 are side views of the display device 10 according to the embodiment of the present disclosure. FIG. 5 is a perspective view illustrating a first state of the display device 10, and FIG. 6 is a perspective view illustrating a second state of the display device 10. FIG. 7 is a side view illustrating the first state of the display device 10, and FIG. 8 is a side view illustrating the second state of the display device 10.

The embodiment of FIGS. 5 through 8 is different from the embodiment of FIGS. 1 through 4 in that a first source circuit board 210 and a second source circuit board 220 are disposed on an edge of a first auxiliary area AA1. In FIGS. 5 through 8, to the extent that a detailed description of one or elements has been omitted, it may be assumed that those elements are at least similar or identical to corresponding elements that are described above with reference to FIGS. 1 through 4.

Referring to FIGS. 5 through 8, each of the first source circuit board 210 and the second source circuit board 220 may be attached to pads disposed on an edge of a sub-area SBA by using an anisotropic conductive film. Therefore, each of the first source circuit board 210 and the second source circuit board 220 may be electrically connected to a pad portion of a display panel 100.

One side of the first auxiliary area AA1 may be opposite the other side of the first auxiliary area AA1 which contacts a main area MA While the one side of the first auxiliary area AA1 is disposed under the main area MA, the other side of the first auxiliary area AA1 may lie in the same plane as the main area MA

Since the one side of the first auxiliary area AA1 is disposed under the main area MA, the first source circuit board 210 and the second source circuit board 220 may be disposed under the main area MA In addition, since a control circuit board 400 is connected to the first source circuit board 210 and the second source circuit board 220, it may be disposed under the main area MA. In addition, since a first circuit board 510 and a second circuit board 520 are connected to the control circuit board 400, they may be disposed under the main area MA

Since the first source circuit board 210, the second source circuit board 220, the control circuit board 400, the first circuit board 510, and the second circuit board 520 are arranged in the first direction DR1 under the main area MA, the first auxiliary area AA1 and a second auxiliary area AA2 may slide within a range in which they are not interfered with by the first source circuit board 210, the second source circuit board 220, the control circuit board 400, the first circuit board 510 and the second circuit board 520. For example, when the display device 10 switches from the second state to the first state, an edge of the second auxiliary area AA2 should not contact the first circuit board 510, and an edge of the second auxiliary area AA2 should not contact the second circuit board 520. For example, when the display device 10 switches from the second state to the first state, the sliding movement of the first auxiliary area AA1 and the second auxiliary area AA2 may be limited. Therefore, it is difficult for the area of the first auxiliary area AA1 and the area of the second auxiliary area AA2 seen from the front of the display device 10 to increase significantly in the second state of the display device 10 compared with in the first state of the display device 10.

Therefore, to increase a difference in the area of the first auxiliary area AA1 and a difference in the area of the second auxiliary area AA2 between the first state and the second state of the display device 10, the first source circuit board 210 and the second source circuit board 220 may be disposed on an edge of the sub-area SBA rather on an edge of the first auxiliary area AA1.

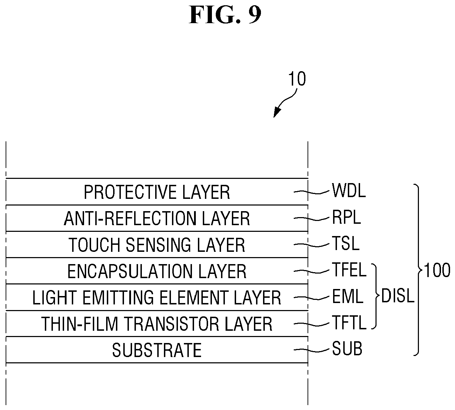

FIG. 9 is a cross-sectional view illustrating the stacked structure of a display device 10 according to an embodiment of the present disclosure.

Referring to FIG. 9, the display device 10 according to the embodiment may include a substrate SUB, a thin-film transistor layer TFTL, a light emitting element layer EML, an encapsulation layer TFEL, a touch sensing layer TSL, an anti-reflection layer RPL, and a protective layer WDL. A display panel 100 may include the substrate SUB, the thin-film transistor layer TFTL, the light emitting element layer EML, and the encapsulation layer TFEL.

The substrate SUB may be made of an insulating material such as polymer resin. For example, the substrate SUB may include polyimide. Each of the substrate SUB may be a flexible substrate that can be bent, folded, rolled, etc. without sustaining damage thereto.

A display layer DISL may be disposed on a surface of the substrate SUB. The display layer DISL may include the thin-film transistor layer TFTL, the light emitting element layer EML, and the encapsulation layer TFEL.

The thin-film transistor layer TFTL may be disposed on the surface of the substrate SUB. The thin-film transistor layer TFTL may include a plurality of thin-film transistors for driving light emitting elements of the light emitting element layer EML

The light emitting element layer EML may be disposed on a surface of the thin-film transistor layer TFTL. The light emitting element layer EML may include light emitting elements that emit light. Each of the light emitting elements may emit light with a predetermined luminance according to an anode voltage and a cathode voltage received from the thin-film transistor layer TFTL.

Each of the light emitting elements may be an organic light emitting diode including an anode, a cathode, and an organic light emitting layer disposed between the anode and the cathode. Alternatively, each of the light emitting elements may be an inorganic light emitting element including an anode, a cathode, and an inorganic semiconductor disposed between the anode and the cathode. Alternatively, each of the light emitting elements may be a quantum dot light emitting element including an anode, a cathode, and a quantum dot light emitting layer disposed between the anode and the cathode. Alternatively, each of the light emitting elements may be a micro light emitting diode.

The encapsulation layer TFEL may be disposed on a surface of the light emitting element layer EML The encapsulation layer TFEL may include at least one inorganic layer or may include at least one inorganic layer and at least one organic layer. Alternatively, the encapsulation layer TFEL may be a glass substrate or an encapsulation film.

The touch sensing layer TSL may be disposed on a surface of the encapsulation layer TFEL. The touch sensing layer TSL may include a plurality of sensor electrodes SE to sense a touch input.

The anti-reflection layer RPL may be disposed on a surface of the touch sensing layer TSL. The anti-reflection layer RPL may prevent a decrease in image visibility of the display panel 100 due to reflection of external light. The anti-reflection layer RPL may include a linear polarizer and a retardation film such as a quarter-wave (1J4) plate. Alternatively, the anti-reflection layer RPL may include color filters that selectively transmit light of a specific wavelength.

The protective layer WDL may be disposed on a surface of the anti-reflection layer RPL. The protective layer WDL may be a cover window made of polymer resin or glass. The protective layer WDL may be attached to the surface of the anti-reflection layer RPL by a transparent adhesive film or a transparent adhesive.

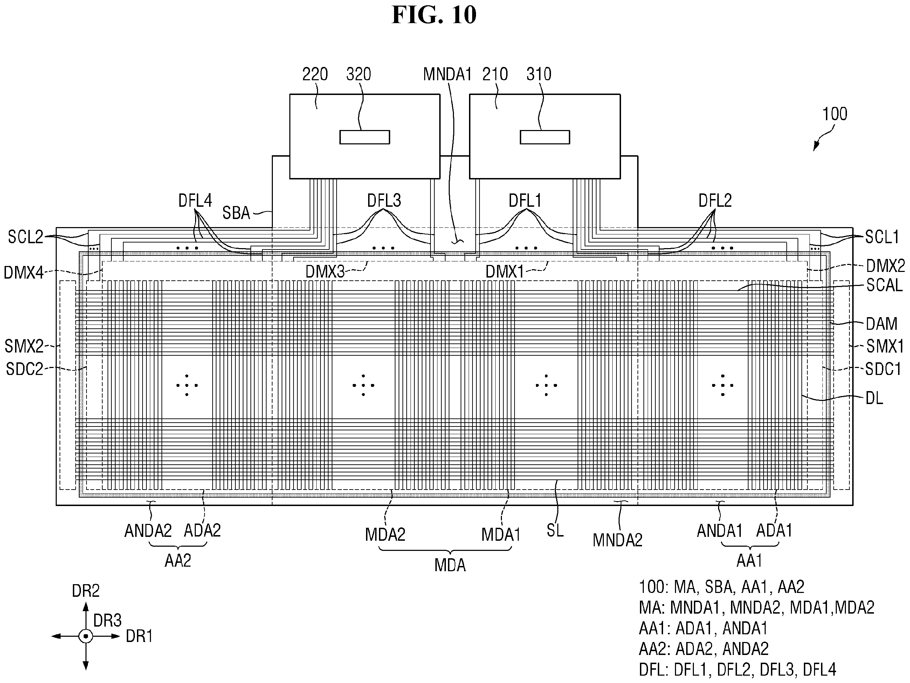

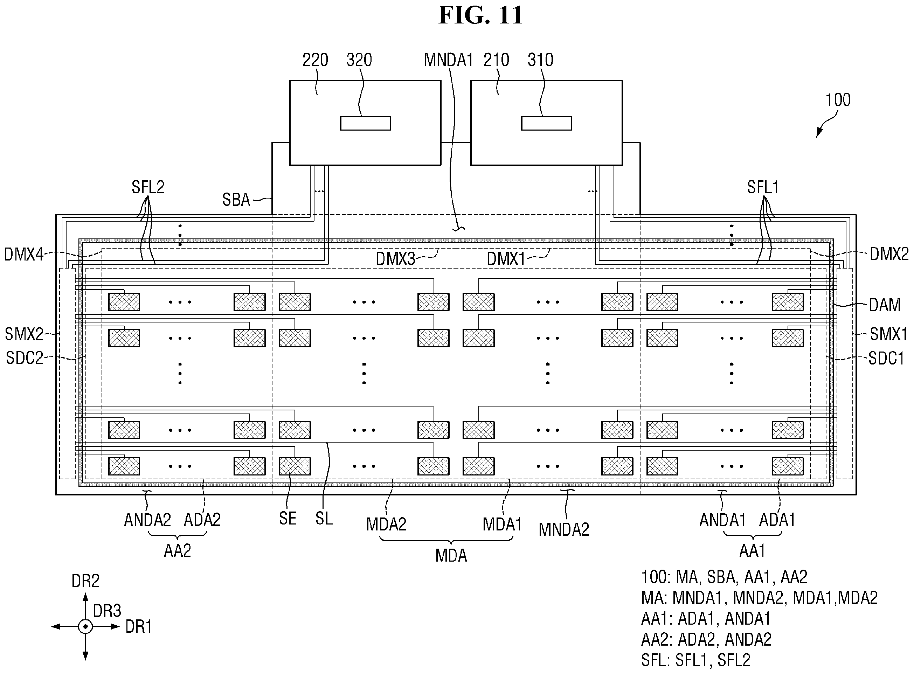

FIG. 10 is a plan view illustrating a layout of scan lines SCAL, data lines DL, a first scan driver SDC1, a second scan driver SDC2, data distribution circuits, a first sensor distribution circuit SMX1, and a second sensor distribution circuit SMX2 of a display layer DISL of a display panel 100 according to an embodiment of the present disclosure. FIG. 11 is a plan view illustrating a layout of sensor electrodes SE and sensor lines SL of a touch sensing layer TSL of the display panel 100 according to the embodiment.

Referring to FIGS. 10 and 11, a main area MA may include a first main display area MDA1, a second main display area MDA2, a first main non-display area MNDA1, and a second main non-display area MNDA2. A first auxiliary area AA1 may include a first auxiliary display area ADA1 and a first auxiliary non-display area ANDA1. A second auxiliary area AA2 may include a second auxiliary display area ADA2 and a second auxiliary non-display area ANDA2.

The first main display area MDA1 may be disposed adjacent to the first auxiliary display area ADA1, and the second main display area MDA2 may be disposed adjacent to the second auxiliary display area ADA2. The first main display area MDA1 may be disposed between the first auxiliary display area ADA1 and the second main display area MDA2, and the second main display area MDA2 may be disposed between the second auxiliary display area ADA2 and the first main display area MDA1.

Pixels may be disposed in each of the first main display area MDA1, the second main display area MDA2, the first auxiliary display area ADA1, and the second auxiliary display area ADA2. Each of the pixels may include a plurality of emission units to display an image.

In non-display areas, especially in all non-display areas, that is the first main non-display area MNDA1, the second main non-display area MNDA2, the first auxiliary non-display area ANDA1, and the second auxiliary non-display area ANDA2, no pixels may be disposed. In other words, some or all non-display areas may be free of pixels and do not display an image, contrary to the display areas.

The first main non-display area MNDA1 may be disposed on one side of the first main display area MDA1 and the second main display area MDA2, and the second main non-display area MNDA2 may be disposed on the other side of the first main display area MDA1 and the second main display area MDA2. The one side of the first main display area MDA1 and the second main display area MDA2 may be a side adjacent to a sub-area SBA. The first main non-display area MNDA1 may be disposed between the first main display area MDA1 and the sub-area SBA and between the second main display area MDA2 and the sub-area SBA. The second main non-display area MNDA2 may be disposed one side of the first main display area MDA1 and the second main display area MDA2.

The first auxiliary non-display area ANDA1 may be disposed on sides of the first auxiliary display area ADA1, excluding a side adjacent to the first main display area MDA1. The first auxiliary non-display area ANDA1 may be disposed on upper, lower, and right sides of the first auxiliary display area ADA1. The first auxiliary non-display area ANDA1 may be disposed on upper, lower, and right edges of the first auxiliary area AA1.

The second auxiliary non-display area ANDA2 may be disposed on sides of the second auxiliary display area ADA2, excluding a side adjacent to the second main display area MDA2. The second auxiliary non-display area ANDA2 may be disposed on upper, lower, and left sides of the second auxiliary display area ADA2. The second auxiliary non-display area ANDA2 may be disposed on upper, lower, and left edges of the second auxiliary area AA2.

The display panel 100 may include the scan lines SCAL, the data lines DL, first scan control lines SCL1, second scan control lines SCL2, data fan-out lines DFL, a first data distribution circuit DMX1, a second data distribution circuit DMX2, a third data distribution circuit DMX3, a fourth data distribution circuit DMX4, the first scan driver SDC1, the second scan driver SDC2, the first sensor distribution circuit SMX1, the second sensor distribution circuit SMX2, and a dam DAM disposed in the display layer DISL. The display panel 100 may include the sensor electrodes SE, the sensor lines SL, and sensor fan-out lines SFL disposed in the touch sensing layer TSL.

The scan lines SCAL may be disposed in the first main display area MDA1, the second main display area MDA2, the first auxiliary display area ADA1, and the second auxiliary display area ADA2. The scan lines SCAL may extend in the first direction DR1 and may be arranged in the second direction DR2. The scan lines SCAL may be connected to the first scan driver SDC1 and the second scan driver SDC2 to receive scan signals.

The data lines DL may be disposed in the first main display area MDA1, the second main display area MDA2, the first auxiliary display area ADA1, and the second auxiliary display area ADA2. The data lines DL may extend in the second direction DR2 and may be arranged in the first direction DR1. The data lines DL may be connected to the first data distribution circuit DMX1, the second data distribution circuit DMX2, the third data distribution circuit DMX3, and the fourth data distribution circuit DMX4 to receive data voltages.

The pixels may be disposed in the first main display area MDA1, the second main display area MDA2, the first auxiliary display area ADA1, and the second auxiliary display area ADA2. Each of the pixels may include a plurality of subpixels. Each of the subpixels may be connected to at least any one of the scan lines SCAL and any one of the data lines DL. Each of the subpixels may receive a data voltage of a data line DL in response to a scan signal of a scan line SL. Each of the subpixels may emit light with a predetermined luminance according to the data voltage.

The sensor electrodes SE may be disposed in the first main display area MDA1, the second main display area MDA2, the first auxiliary display area ADA1, and the second auxiliary display area ADA2. The sensor electrodes SE may be arranged in a matrix form. Each of the sensor electrodes SE may be longer in the first direction DR1 than in the second direction DR2.

The sensor lines SL may be connected in a one-to-one manner to the sensor electrodes SE. Each of the sensor lines SL may be connected to a corresponding sensor electrode SE. The sensor lines SL may extend in the first direction DR1. The sensor lines SL connected to the sensor electrodes SE disposed in the first main display area MDA1 and the first auxiliary display area ADA1 may be connected to the first sensor distribution circuit SMX1. The sensor lines SL connected to the sensor electrodes SE disposed in the second main display area MDA2 and the second auxiliary display area ADA2 may be connected to the second sensor distribution circuit SMX2.

The first scan control lines SCL1 may be disposed in the sub-area SBA, the first main non-display area MNDA1, and the first auxiliary non-display area ANDA1. An end of each of the first scan control lines SCL1 may be connected to a first source circuit board 210 through a pad disposed in the sub-area SBA. The other end of each of the first scan control lines SCL1 may be connected to the first scan driver SDC1 disposed in the first auxiliary non-display area ANDA1. Accordingly, the first scan control lines SCL1 may be electrically connected to the first source circuit board 210 and the first scan driver SDC1. Therefore, first scan control signals of a timing control circuit 500 may be supplied to the first scan driver SDC1 through the first scan control lines SCL1.

The second scan control lines SCL2 may be disposed in the sub-area SBA, the second main non-display area MNDA2, and the second auxiliary non-display area ANDA2. An end of each of the second scan control lines SCL2 may be connected to a second source circuit board 220 through a pad disposed in the sub-area SBA. The other end of each of the second scan control lines SCL2 may be connected to the second scan driver SDC2 disposed in the second auxiliary non-display area ANDA2. Accordingly, the second scan control lines SCL2 may be electrically connected to the second source circuit board 220 and the second scan driver SDC2. Therefore, second scan control signals of the timing control circuit 500 may be supplied to the second scan driver SDC2 through the second scan control lines SCL2.

The data fan-out lines DFL may be disposed in the sub-area SBA, the first main non-display area MNDA1, the first auxiliary non-display area ANDA1, and the second auxiliary non-display area ANDA2. An end of each of the data fan-out lines DFL may be connected to the first source circuit board 210 or the second source circuit board 220 through a pad disposed in the sub-area SBA. The other end of each of the data fan-out lines DFL may be connected to the first data distribution circuit DMX1 disposed in the first main non-display area MNDA1, the second data distribution circuit DMX2 disposed in the first auxiliary non-display area ANDA1, the third data distribution circuit DMX3 disposed in the first main non-display area MNDA1, or the fourth data distribution circuit DMX4 disposed in the second auxiliary non-display area ANDA2. Accordingly, the data fan-out lines DFL may be electrically connected to a first source driving circuit 310, a second source driving circuit 320, the first data distribution circuit DMX1, the second data distribution circuit DMX2, the third data distribution circuit DMX3, and the fourth data distribution circuit DMX4. Therefore, data voltages of the first source driving circuit 310 and the second source driving circuit 320 may be supplied to the first data distribution circuit DMX1, the second data distribution circuit DMX2, the third data distribution circuit DMX3, and the fourth data distribution circuit DMX4 through the data fan-out lines DFL.

The sensor fan-out lines SFL may be disposed in the sub-area SBA, the first main non-display area MNDA1, the first auxiliary non-display area ANDA1, and the second auxiliary non-display area ANDA2. An end of each of the sensor fan-out lines SFL may be connected to the first source circuit board 210 or the second source circuit board 220 through a pad disposed in the sub-area SBA. The other end of each of the sensor fan-out lines SFL may be connected to the first sensor distribution circuit SMX1 disposed in the first auxiliary non-display area ANDA1 or the second sensor distribution circuit SMX2 disposed in the second auxiliary non-display area ANDA2. Accordingly, the sensor fan-out lines SFL may be electrically connected to the timing control circuit 500, the first sensor distribution circuit SMX1, and the second sensor distribution circuit SMX2. At least some SFL1 of the sensor fan-out lines SFL may at least partially overlap the first data distribution circuit DMX1 and the second data distribution circuit DMX2. At least some other ones SFL2 of the sensor fan-out lines SFL may at least partially overlap the third data distribution circuit DMX3 and the fourth data distribution circuit DMX4.

The first data distribution circuit DMX1 and the third data distribution circuit DMX3 may be disposed in the first main non-display area MNDA1. The first data distribution circuit DMX1 may be disposed adjacent to the first main display area MDA1, and the third data distribution circuit DMX3 may be disposed adjacent to the second main display area MDA2.

The second data distribution circuit DMX2 may be disposed in the first auxiliary non-display area ANDA1, and the fourth data distribution circuit DMX4 may be disposed in the second auxiliary non-display area ANDA2. The second data distribution circuit DMX2 may be disposed adjacent to the first auxiliary display area ADA1, and the fourth data distribution circuit DMX4 may be disposed adjacent to the second auxiliary display area ADA2.

Each of the first data distribution circuit DMX1, the second data distribution circuit DMX2, the third data distribution circuit DMX3, and the fourth data distribution circuit DMX4 may connect the data lines DL and the data fan-out lines DFL in an M:1 ratio (where M is an integer of 2 or greater). Therefore, due to the first data distribution circuit DMX1, the second data distribution circuit DMX2, the third data distribution circuit DMX3, and the fourth data distribution circuit DMX4, the number of pads of the sub-area SBA which are connected to the data fan-out lines DFL may be reduced to less than half the number of the data lines DL. Accordingly, the number of the source circuit boards 210 and 220 and the source driving circuits 310 and 320 may be reduced, thereby reducing manufacturing costs of a display device 10.

The first scan driver SDC1 may be disposed in the first auxiliary non-display area ANDA1, and the second scan driver SDC2 may be disposed in the second auxiliary non-display area ANDA2. The first scan driver SDC1 may be disposed on a right side of the first auxiliary non-display area ANDA1, and the second scan driver SDC2 may be disposed on a left side of the second auxiliary non-display area ANDA2.

The first scan driver SDC1 may receive the first scan control signals through the first scan control lines SCL1. The first scan driver SDC1 may generate scan signals according to the first scan control signals and supply the scan signals to the scan lines SCAL.

The second scan driver SDC2 may receive the second scan control signals through the second scan control lines SCL2. The second scan driver SDC2 may generate scan signals according to the second scan control signals and supply the scan signals to the scan lines SCAL.

The first scan control signals and the second scan control signals may be substantially the same signals. Therefore, the first scan driver SDC1 and the second scan driver SDC2 may be driven in synchronization with each other. For example, the first scan driver SDC1 and the second scan driver SDC2 may supply the same scan signals to the same scan lines SCAL at the same timing.

Any one of the first scan driver SDC1 and the second scan driver SDC2 may be omitted.

The first sensor distribution circuit SMX1 may be disposed in the first auxiliary non-display area ANDA1, and the second sensor distribution circuit SMX2 may be disposed in the second auxiliary non-display area ANDA2. The first sensor distribution circuit SMX1 may be disposed on a right side of the first auxiliary non-display area ANDA1, and the second sensor distribution circuit SMX2 may be disposed on a left side of the second auxiliary non-display area ANDA2.

The first sensor distribution circuit SMX1 may be disposed on a side of the first scan driver SDC1 in the first auxiliary non-display area ANDA1. For example, the first scan driver SDC1 may be disposed between the first auxiliary display area ADA1 and the first sensor distribution circuit SMX1, and the sensor lines SL connected to the first sensor distribution circuit SMX1 may at least partially overlap the first scan driver SDC1.

Alternatively, the first scan driver SDC1 may be disposed on a side of the first sensor distribution circuit SMX1 in the first auxiliary non-display area ANDA1. For example, the first sensor distribution circuit SMX1 may be disposed between the first auxiliary display area ADA1 and the first scan driver SDC1 and the scan lines SCAL connected to the first scan driver SDC1 may at least partially overlap the first sensor distribution circuit SMX1.

The second sensor distribution circuit SMX2 may be disposed on a side of the second scan driver SDC2 in the second auxiliary non-display area ANDA2. For example, the second scan driver SDC2 may be disposed between the second auxiliary display area ADA2 and the second sensor distribution circuit SMX2. Therefore, the sensing lines SL connected to the second sensor distribution circuit SMX2 may at least partially overlap the second scan driver SDC2.

Alternatively, the second scan driver SDC2 may be disposed on a side of the second sensor distribution circuit SMX2 in the second auxiliary non-display area ANDA2. For example, the second sensor distribution circuit SMX2 may be disposed between the second auxiliary display area ADA2 and the second scan driver SDC2 and the scan lines SCAL connected to the second scan driver SDC2 may at least partially overlap the second sensor distribution circuit SMX2

Each of the first sensor distribution circuit SMX1 and the second sensor distribution circuit SMX2 may connect the sensor lines SL and the sensor fan-out lines SFL in an N:1 ratio (where N is an integer of 2 or greater). Therefore, due to the first sensor distribution circuit SMX1 and the second sensor distribution circuit SMX2, the number of pads of the sub-area SBA which are connected to the sensor fan-out lines SFL may be reduced to less than half the number of the sensor lines SL. Accordingly, the number of the source circuit boards 210 and 220 and the source driving circuits 310 and 320 may be reduced, thereby reducing the manufacturing costs of the display device 10.

The dam DAM may be disposed in the first main non-display area MNDA1, the second main non-display area MNDA2, the first auxiliary non-display area ANDA1, and the second auxiliary non-display area ANDA2. The dam DAM may at least partially surround upper and lower sides of a main display area MDA, upper and lower sides of the first auxiliary non-display area ANDA1, upper and lower sides of the second auxiliary non-display area ANDA2, upper, right and lower sides of the first scan driver SDC1, and upper, left and lower sides of the second scan driver SDC2.

The dam DAM may be disposed on one side of the first data distribution circuit DMX1 and one side of the third data distribution circuit DMX3 in the first main non-display area MNDA1. The one side of the first data distribution circuit DMX1 may be a side opposite the other side of the first data distribution circuit DMX1 which is adjacent to the main display area MDA. The one side of the third data distribution circuit DMX3 may be a side opposite the other side of the third data distribution circuit DMX3 which is adjacent to the main display area MDA.

The dam DAM may be disposed between the first scan driver SDC1 and the first sensor distribution circuit SMX1 in the first auxiliary non-display area MNDA1. The dam DAM may be disposed between the second scan driver SDC2 and the second sensor distribution circuit SMX2 in the second auxiliary non-display area MNDA2.

As illustrated in FIGS. 10 and 11, to reduce the number of pads of the sub-area SBA which are connected to the data fan-out lines DFL to less than half the number of the data lines DL, the first data distribution circuit DMX1, the second data distribution circuit DMX2, the third data distribution circuit DMX3, and the fourth data distribution circuit DMX4 are required. In addition, to reduce the number of pads of the sub-area SBA which are connected to the sensor fan-out lines SFL to less than half the number of the sensor lines SL, the first sensor distribution circuit SMX1 and the second sensor distribution circuit SMX2 are required.

However, when the first source circuit board 210 and the second source circuit board 220 are disposed on an edge of the sub-area SBA, the first data distribution circuit DMX1, the second data distribution circuit DMX2, the third data distribution circuit DMX3, and the fourth data distribution circuit DMX4 are disposed in the first main non-display area NDA1, the first auxiliary non-display area ANDA1, and the second auxiliary non-display area ANDA2 which are adjacent to the sub-area SBA. Accordingly, there is no space left for the first sensor distribution circuit SMX1 and the second sensor distribution circuit SMX2 in the first main non-display area NDA1, the first auxiliary non-display area ANDA1, and the second auxiliary non-display area ANDA2 which are adjacent to the sub-area SBA. Therefore, the first sensor distribution circuit SMX1 may be disposed on the right side of the first auxiliary non-display area ANDA1, and the second sensor distribution circuit SMX2 may be disposed on the left side of the second auxiliary non-display area ANDA2. In this case, the sensor lines SL may extend in the first direction DR1 so as to be connected to the first sensor distribution circuit SMX1 or the second sensor distribution circuit SMX2.

Thus, when the sensor lines SL are disposed in the second direction DR2, they may be connected to the first source circuit board 210 and the second source circuit board 220 by the shortest distance. However, due to the space problem, the first sensor distribution circuit SMX1 is disposed on the right side of the first auxiliary non-display area ANDA1, and the second sensor distribution circuit SMX2 is disposed on the left side of the second auxiliary non-display area ANDA2. Accordingly, the sensor lines SL may extend in the first direction DR1 so as to be connected to the first sensor distribution circuit SMX1 or the second sensor distribution circuit SMX2.

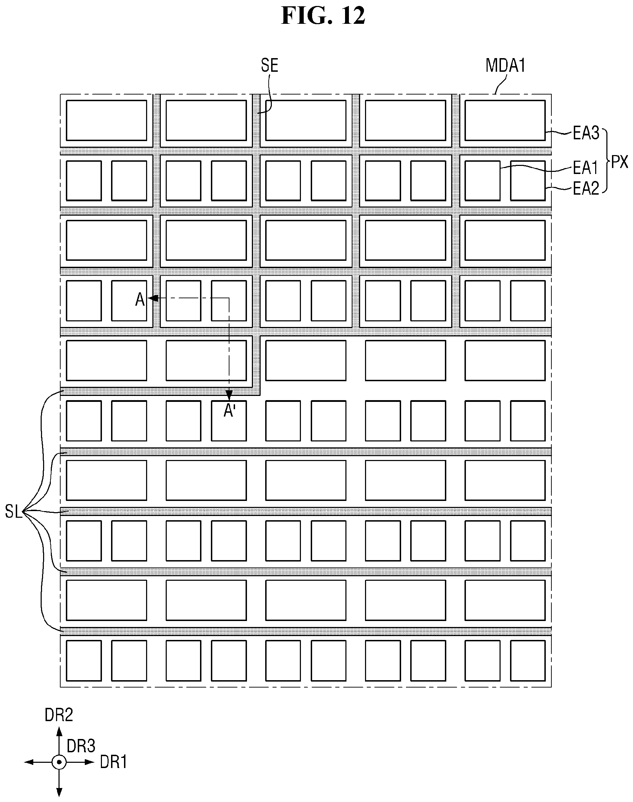

FIG. 12 is a plan view illustrating a layout of sensor electrodes SE, sensing lines SL, and pixels PX according to an embodiment of the present disclosure. In FIG. 12, the sensor electrodes SE, the sensor lines SL, and the pixels PX disposed in the first main display area MDA1 are illustrated.

Referring to FIG. 12, each of the pixels PX may include a first emission unit EA1, a second emission unit EA2, and a third emission unit EA3. The first emission unit EA1 may be an area that emits light of a first color, for example, emits light in a red wavelength band. The second emission unit EA2 may be an area that emits light of a second color, for example, emits light in a blue wavelength band. The third emission unit EA3 may be an area that emits light of a third color, for example, emits light in a green wavelength band.

The pixels PX may be arranged in a matrix form. For example, the pixels PX may be arranged in the first direction DR1 and the second direction DR2. In each of the pixels PX, the first emission unit EA1 and the second emission unit EA2 may be disposed in the first direction DR1. In each of the pixels PX, the first emission unit EA1 and the third emission unit EA3 may be disposed in the second direction DR2, and the second emission unit EA2 and the third emission unit EA3 may be disposed in the second direction DR2.

A length of the third emission unit EA3 in the first direction DR1 may be greater than a length of the third emission unit EA3 in the second direction DR2. A length of the first emission unit EA1 in the first direction DR1 may be similar to a length of the first emission unit EA1 in the second direction DR2. A length of the second emission unit EA2 in the first direction DR1 may also be similar to a length of the second emission unit EA2 in the second direction DR2.

The area of the third emission unit EA3 may be larger than the area of the first emission unit EA1 and the area of the second emission unit EA2. The area of the first emission unit EA1 and the area of the second emission unit EA2 may be substantially the same.

Each of the sensor electrodes SE may have a mesh shape or a net shape in a plan view. Therefore, the sensor electrodes SE might not overlap the first emission unit EA1, the second emission unit EA2, and the third emission unit EA3. For example, since the sensor electrodes SE do not cover the first emission unit EA1, the second emission unit EA2, and the third emission unit EA3, light of the first emission unit EA1, light of the second emission unit EA2, and light of the third emission unit EA3 may be emitted upward without being blocked by the sensor electrodes SE.

Each of the sensor lines SL may be connected to a corresponding sensor electrode SE. The sensor lines SL might not overlap the first emission unit EA1, the second emission unit EA2, and the third emission unit EA3. For example, any one of the sensor lines SL may be disposed between the first emission unit EA1 and the third emission unit EA3 adjacent to each other in the second direction DR2 and between the second emission unit EA2 and the third emission unit EA3 adjacent to each other in the second direction DR2. In addition, any one of sensor lines SL may be disposed between the pixels PX adjacent to each other in the first direction DR1. For example, any one of the sensor lines SL may be disposed between the first emission unit EA1 and the second emission unit EA2 adjacent to each other in the first direction DR1 and between the third emission units EA3 adjacent to each other in the first direction DR1. For example, since the sensor lines SL do not cover the first emission unit EA1, the second emission unit EA2, and the third emission unit EA3, light of the first emission unit EA1, light of the second emission unit EA2, and light of the third emission unit EA3 may be emitted upward without being blocked by the sensor lines SL.

As illustrated in FIG. 12, each of the pixels PX includes the third emission unit EA3 extending in the first direction DR1 and the first emission unit EA1 and the second emission unit EA2 disposed adjacent to the third emission unit EA3 in the second direction DR2. Accordingly, even if the sensor lines SL extend in the first direction DR1, they might not overlap the first emission unit EA1, the second emission unit EA2, and the third emission unit EA3. Therefore, light of the second emission unit EA2, and light of the third emission unit EA3 may be emitted upward without being blocked by the sensor lines SL.

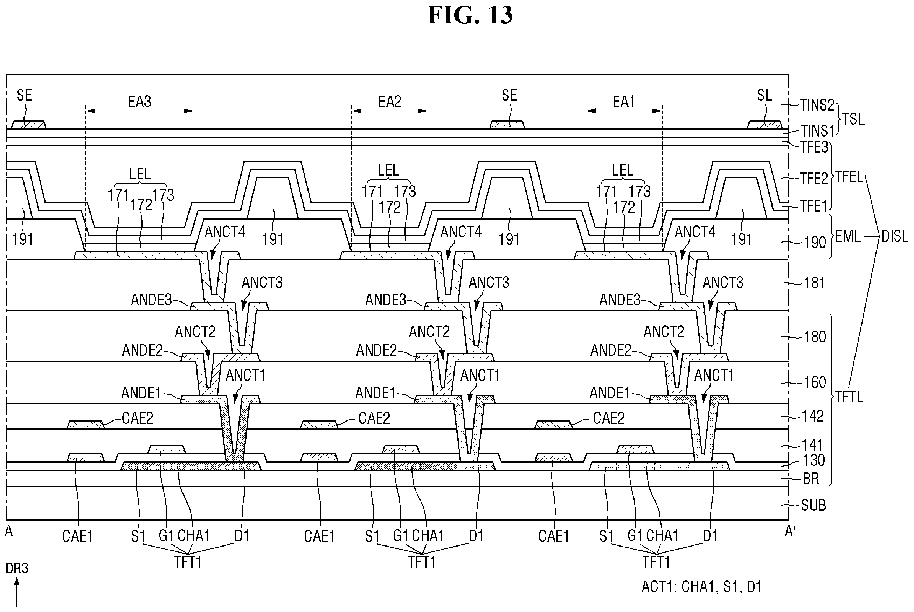

FIG. 13 is a cross-sectional view of an example of the display panel 100 taken along line A-A' of FIG. 12.

Referring to FIG. 13, a barrier layer BR may be disposed on a substrate SUB. The substrate SUB may be made of an insulating material such as a polymer resin. For example, the substrate SUB may be made of polyimide. The substrate SUB may be a flexible substrate that can be bent, folded, rolled, stretched, etc. without sustaining damage such as cracking.

The barrier layer BR is a layer for protecting transistors of a thin-film transistor layer TFTL and light emitting layers 172 of a light emitting element layer EML from moisture introduced through the substrate SUB which is vulnerable to moisture penetration. The barrier layer BR may be composed of a plurality of inorganic layers that are alternately stacked. For example, the barrier layer BR may be a multilayer structure in which one or more inorganic layers selected from a silicon nitride layer, a silicon oxynitride layer, a silicon oxide layer, a titanium oxide layer, and an aluminum oxide layer are alternately stacked.

First thin-film transistors TFT1 may be disposed on the barrier layer BR. Each of the first thin-film transistors TFT1 may include a first active layer ACT! and a first gate electrode G1.

The first active layer ACT1 of each of the first thin-film transistors TFT1 may be disposed on the barrier layer BR. The first active layer ACT of each of the first thin-film transistors TFT1 may include polycrystalline silicon, monocrystalline silicon, low-temperature polycrystalline silicon, amorphous silicon, or an oxide semiconductor.

The first active layer ACT1 may include a first channel region CHA1, a first source region S1, and a first drain region D1. The first channel region CHA1 may be a region overlapped by the first gate electrode G1 in the third direction DR3 which is the thickness direction of the substrate SUB. The first source region S1 may be disposed on a side of the first channel region CHA1, and the first drain region D1 may be disposed on the other side of the first channel region CHA1. The first source region S1 and the first drain region D1 may be regions not overlapped by the first gate electrode G1 in the third direction DR3. The first source region S1 and the first drain region D1 may be conductive regions by doping a silicon semiconductor or an oxide semiconductor with ions or impurities.

A first gate insulating layer 130 may be disposed on the first active layers ACT! of the first thin-film transistors TFT1. The first gate insulating layer 130 may be made of an inorganic layer such as a silicon nitride layer, a silicon oxynitride layer, a silicon oxide layer, a titanium oxide layer, or an aluminum oxide layer.

The first gate electrodes G1 of the first thin-film transistors TFT1 and first capacitor electrodes CAE1 may be disposed on the first gate insulating layer 130. The first gate electrodes G1 may at least partially overlap the first active layers ACT! in the third direction DR3. Although the first gate electrodes G1 and the first capacitor electrodes CAE1 are spaced apart from each other in FIG 13, they may also be connected to each other. Each of the first gate electrodes G1 and the first capacitor electrodes CAE1 may be a single layer or a multilayer structure made of any one or more of molybdenum (Mo), aluminum (Al), chromium (Cr), gold (Au), titanium (Ti), nickel (Ni), neodymium (Nd), copper (Cu), and alloys of the same.

A first interlayer insulating film 141 may be disposed on the first gate electrodes G1 of the first thin-film transistors TFT1 and the first capacitor electrodes CAE1. The first interlayer insulating film 141 may be made of an inorganic layer such as a silicon nitride layer, a silicon oxynitride layer, a silicon oxide layer, a titanium oxide layer, or an aluminum oxide layer. The first interlayer insulating film 141 may be composed of a plurality of inorganic layers.

Second capacitor electrodes CAE2 may be disposed on the first interlayer insulating film 141. The second capacitor electrodes CAE2 may at least partially overlap the first capacitor electrodes CAE1 in the third direction DR3. When the first capacitor electrodes CAE1 are connected to the first gate electrodes G1, the second capacitor electrodes CAE2 may at least partially overlap the first gate electrodes G1 in the third direction DR3. Since the first interlayer insulating film 141 has a predetermined dielectric constant, the first capacitor electrodes CAE1, the second capacitor electrodes CAE2, and the first interlayer insulating film 141 disposed between them may form capacitors. Each of the second capacitor electrodes CAE2 may be a single layer or a multilayer structure made of any one or more of molybdenum (Mo), aluminum (Al), chromium (Cr), gold (Au), titanium (Ti), nickel (Ni), neodymium (Nd), copper (Cu), and alloys of the same.

A second interlayer insulating film 142 may be disposed on the second capacitor electrodes CAE2. The second interlayer insulating film 142 may be made of an inorganic layer such as a silicon nitride layer, a silicon oxynitride layer, a silicon oxide layer, a titanium oxide layer, or an aluminum oxide layer. The second interlayer insulating film 142 may be composed of a plurality of inorganic layers.

First anode connection electrodes ANDE1 may be disposed on the second interlayer insulating film 142. Each of the first anode connection electrodes ANDE1 may be connected to the first drain region D1 of a first thin-film transistor TFT1 through a first connection contact hole ANCT1 passing through the first gate insulating layer 130, the first interlayer insulating film 141 and the second interlayer insulating film 142. Each of the first anode connection electrodes ANDE1 may be a single layer or a multilayer structure made of any one or more of molybdenum (Mo), aluminum (Al), chromium (Cr), gold (Au), titanium (Ti), nickel (Ni), neodymium (Nd), copper (Cu), and alloys of the same.

A first planarization layer 160 may be disposed on the first anode connection electrodes ANDE1 to planarize steps due to the first thin-film transistors TFT1. The first planarization layer 160 may be made of an organic layer such as acryl resin, epoxy resin, phenolic resin, polyamide resin, or polyimide resin.

Second anode connection electrodes ANDE2 may be disposed on the first planarization layer 160. Each of the second anode connection electrodes ANDE2 may be connected to a first anode connection electrode ANDE1 through a second connection contact hole ANCT2 passing through the first planarization layer 160. Each of the second anode connection electrodes ANDE2 may be a single layer or a multilayer structure made of any one or more of molybdenum (Mo), aluminum (Al), chromium (Cr), gold (Au), titanium (Ti), nickel (Ni), neodymium (Nd), copper (Cu), and alloys of the same.

A second planarization layer 180 may be disposed on the second anode connection electrodes ANDE2. The second planarization layer 180 may be made of an organic layer such as acryl resin, epoxy resin, phenolic resin, polyamide resin, or polyimide resin.

Third anode connection electrodes ANDE3 may be disposed on the second planarization layer 180. Each of the third anode connection electrodes ANDE3 may be connected to a second anode connection electrode ANDE2 through a third connection contact hole ANCT3 passing through the second planarization layer 180. Each of the third anode connection electrodes ANDE3 may be a single layer or a multilayer structure made of any one or more of molybdenum (Mo), aluminum (Al), chromium (Cr), gold (Au), titanium (Ti), nickel (Ni), neodymium (Nd), copper (Cu), and alloys of the same.

A third planarization layer 181 may be disposed on the third anode connection electrodes ANDE3. The third planarization layer 181 may be made of an organic layer such as acryl resin, epoxy resin, phenolic resin, polyamide resin, or polyimide resin.

Light emitting elements LEL and a bank 190 may be disposed on the third planarization layer 181. Each of the light emitting elements LEL includes a pixel electrode 171, the light emitting layer 172, and a common electrode 173.

The pixel electrode 171 may be disposed on the third planarization layer 181. The pixel electrode 171 may be connected to each of the third anode connection electrodes ANDE3 through a fourth connection contact hole ANCT4 passing through the third planarization layer 181.

In a top emission structure in which light is emitted from the light emitting layer 172 toward the common electrode 173, the pixel electrode 171 may be made of a metal material having high reflectivity of visible light, such as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide. The APC alloy is an alloy of silver (Ag), palladium (Pd), and copper (Cu).

The bank 190 may be formed on the third planarization layer 181 to separate the pixel electrodes 171 so as to define the first emission unit EA1, the second emission unit EA2, and the third emission unit EA3. The bank 190 may cover edges of the pixel electrodes 171. The bank 190 may be made of an organic layer such as acryl resin, epoxy resin, phenolic resin, polyamide resin, or polyimide resin.

Each of the first emission unit EA1, the second emission unit EA2, and the third emission unit EA3 is an area in which the pixel electrode 171, the light emitting layer 172, and the common electrode 173 are sequentially stacked so that holes from the pixel electrode 171 and electrons from the common electrode 173 recombine together in the light emitting layer 172 to emit light.

The light emitting layer 172 may be disposed on the pixel electrode 171 and the bank 190. The light emitting layer 172 may include an organic material to emit light of a predetermined color. For example, the light emitting layer 172 includes a hole transporting layer, an organic material layer, and an electron transporting layer.

The common electrode 173 may be disposed on the light emitting layer 172. The common electrode 173 may cover the light emitting layer 172. The common electrode 173 may be a common layer commonly formed in the first emission unit EA1, the second emission unit EA2, and the third emission unit EA3. A capping layer may be formed on the common electrode 173.

In the top emission structure, the common electrode 173 may be made of a transparent conductive material (TCO) capable of transmitting light, such as indium tin oxide (ITO) or indium zinc oxide (IZO), or a semi-transmissive conductive material such as magnesium (Mg), silver (Ag) or an alloy of Mg and Ag. When the common electrode 173 is made of a semi-transmissive conductive material, light output efficiency may be increased by a microcavity.

An encapsulation layer TFEL may be disposed on the common electrode 173. The encapsulation layer TFEL includes at least one inorganic layer to prevent oxygen or moisture from permeating into the light emitting element layer EML In addition, the encapsulation layer TFEL includes at least one organic layer to protect the light emitting element layer EML from foreign substances such as dust. For example, the encapsulation layer TFEL includes a first encapsulating inorganic layer TFE1, an encapsulating organic layer TFE2, and a second encapsulating inorganic layer TFE3.

The first encapsulating inorganic layer TFE1 may be disposed on the common electrode 173, the encapsulating organic layer TFE2 may be disposed on the first encapsulating inorganic layer TFE1, and the second encapsulating inorganic layer TFE3 may be disposed on the encapsulating organic layer TFE2. Each of the first encapsulating inorganic layer TFE1 and the second encapsulating inorganic layer TFE3 may be a multilayer structure in which one or more inorganic layers selected from a silicon nitride layer, a silicon oxynitride layer, a silicon oxide layer, a titanium oxide layer, and an aluminum oxide layer are alternately stacked. The encapsulating organic layer TFE2 may be an organic layer such as acryl resin, epoxy resin, phenolic resin, polyamide resin, or polyimide resin.

A touch sensing layer TSL may be disposed on the encapsulation layer TFEL. The touch sensing layer TSL includes a first sensor insulating layer TINS1, a second sensor insulating layer TINS2, the sensor electrodes SE, and the sensor lines SL.

The first sensor insulating layer TINS1 may be disposed on the second encapsulating inorganic layer TFE3. The first sensor insulating layer TINS 1 may be made of an inorganic layer such as a silicon nitride layer, a silicon oxynitride layer, a silicon oxide layer, a titanium oxide layer, or an aluminum oxide layer.

The sensor electrodes SE and the sensor lines SL may be disposed on the first sensor insulating layer TINS 1. The sensor electrodes SE and the sensor lines SL might not overlap the emission units EA1 through EA3 in the third direction DR3. Each of the sensor electrodes SE and the sensor lines SL may be a single layer or a multilayer structure made of any one or more of molybdenum (Mo), aluminum (Al), chromium (Cr), gold (Au), titanium (Ti), nickel (Ni), neodymium (Nd), copper (Cu), and alloys of the same.

The second sensor insulating layer TINS2 is disposed on the sensor electrodes SE and the sensor lines SL. The second sensor insulating layer TINS2 may be made of an inorganic layer such as a silicon nitride layer, a silicon oxynitride layer, a silicon oxide layer, a titanium oxide layer, or an aluminum oxide layer. Alternatively, the second sensor insulating layer TINS2 may be made of an organic layer such as acryl resin, epoxy resin, phenolic resin, polyamide resin, or polyimide resin.

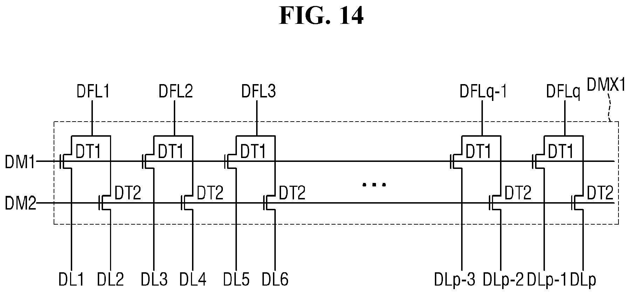

FIG 14 is a circuit diagram of a first data distribution circuit DMX1 according to an embodiment of the present disclosure.

Referring to FIG 14, the first data distribution circuit DMX1 may temporally divide data voltages supplied to data fan-out lines DFL1 through DFLq (where q is an integer of 2 or greater) and distribute the temporally divided data voltages to data lines DL1 through DLp (wherep is an integer satisfying p=2q) by using data distribution transistors DT1 and DT2 sequentially turned on by distribution control signals supplied to data distribution control lines DM1 and DM2. In FIG 14, the first data distribution circuit DMX1 connects the data lines DL1 through DLp and the data fan-out lines DFL1 through DFLq in a 2:1 ratio to temporally divide data voltages supplied to one data fan-out line and distribute the temporally divided data voltages to two data lines. However, embodiments of the present specification are not necessarily limited thereto.

The first data distribution circuit DMX1 may include first data distribution transistors DT1 and second data distribution transistors DT2.

First data gate electrodes of the first data distribution transistors DT1 may be commonly connected to a first data distribution control line DM1. Therefore, the first data distribution transistors DT1 may be commonly turned on or turned off according to a first data distribution control signal of the first data distribution control line DM1.

Second data gate electrodes of the second data distribution transistors DT2 may be commonly connected to a second data distribution control line DM2. Therefore, the second data distribution transistors DT2 may be commonly turned on or turned off according to a second data distribution control signal of the second data distribution control line DM2.

A first data distribution transistor DT1 and a second data distribution transistor DT2 connected to one data fan-out line may be connected to different data lines. For example, the first data distribution transistor DT1 may be connected to any one of odd-numbered data lines DL1, DL3, DL5, ..., DLp-3 and DLp-1, and the second data distribution transistor DT2 may be connected to any one of even-numbered data lines DL2, DL4, DL6, ..., DLp-2 and DLp.

When the first data distribution control signal of a gate-on voltage is transmitted to the first data distribution control line DM1, the first data distribution transistors DT1 may be turned on. Accordingly, the data fan-out lines DFL1 through DFLq may be connected to the odd-numbered data lines DL1, DL3, DL5, ..., DLp-3 and DLp-1.

When the second data distribution control signal of the gate-on voltage is transmitted to the second data distribution control line DM2, the second data distribution transistors DT2 may be turned on. Accordingly, the data fan-out lines DFL1 through DFLq may be connected to the even-numbered data lines DL2, DL4, DL6, ..., DLp-2 and DLp.

The first data distribution transistors DT1 and the second data distribution transistors DT2 of the first data distribution circuit DMX1 may be formed as thin-film transistors. In addition, although the first data distribution transistors DT1 and the second data distribution transistors DT2 of the first data distribution circuit DMX1 are formed as p-type metal-oxide-semiconductor field-effect transistors (MOSFETs) in FIG 14, embodiments of the present specification are not necessarily limited thereto. For example, the first data distribution transistors DT1 and the second data distribution transistors DT2 of the first data distribution circuit DMX1 may also be formed as n-type MOSFETs.

The second data distribution circuit DMX2, the third data distribution circuit DMX3, and the fourth data distribution circuit DMX4 may be substantially the same as the first data distribution circuit DMX1 described above with reference to FIG 14, and thus a description thereof will be omitted.

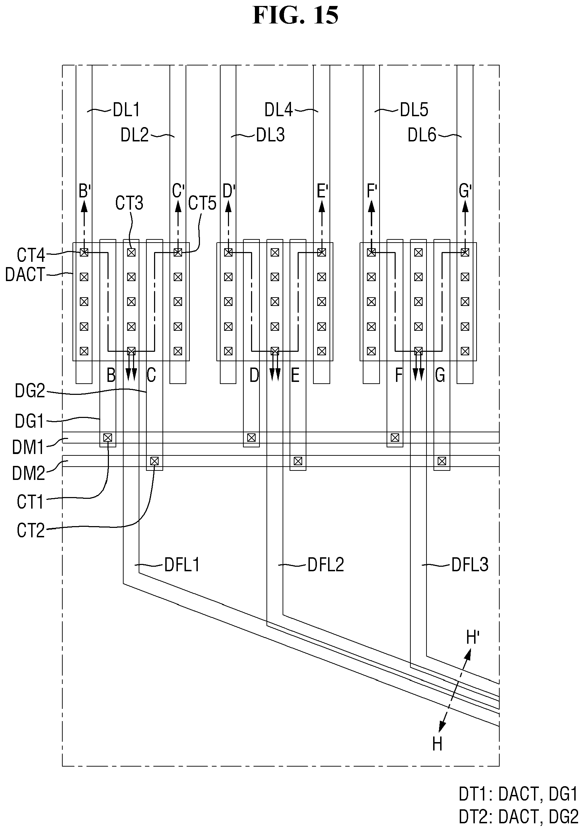

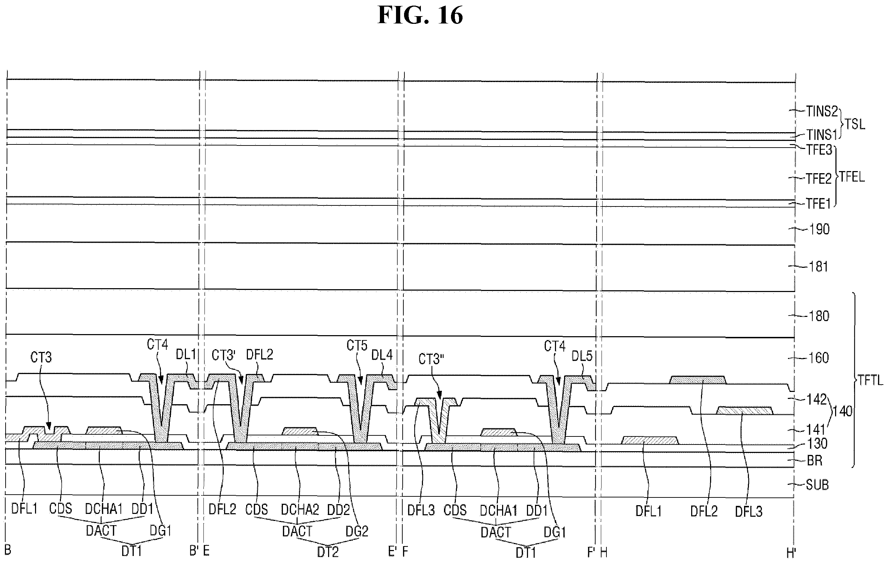

FIG 15 is a plan view illustrating a layout of an example of data distribution transistors connected to a first data fan-out line DFL1, a second data fan-out line DFL2, and a third data fan-out line DFL3 of FIG 14. FIG 16 is a cross-sectional view of an example of the display panel 100 taken along lines B-B', E-E', F-F', and H-H' of FIG 15.

An example of the display panel 100 taken along line C-C' of FIG 16 is substantially the same as an example of the display panel 100 taken along line B-B' of FIG 16, an example of the display panel 100 taken along line D-D' of FIG 16 is substantially the same as an example of the display panel 100 taken along line E-E' of FIG 16, and an example of the display panel 100 taken along line G-G' of FIG 16 is substantially the same as an example of the display panel 100 taken along line F-F' of FIG 16, and thus it may be assumed that this structure is at least similar or identical to corresponding structures described herein and illustrated in the drawings.

Referring to FIGS. 15 and 16, a first data distribution transistor DT1 may include a data active layer DACT and a first data gate electrode DG1, and a second data distribution transistor DT2 may include the data active layer DACT and a second data gate electrode DG2. For example, the first data distribution transistor DT1 and the second data distribution transistor DT2 may share the data active layer DACT.

The data active layer DACT may be disposed on the barrier layer BR. The data active layer DACT may include poly crystalline silicon, monocrystalline silicon, low-temperature polycrystalline silicon, amorphous silicon, or an oxide semiconductor. The data active layer DACT may be made of the same material as the first active layer ACT1.

The data active layer DACT may include a first data channel region DCHA1, a second data channel region DCHA2, a common data source region CDS, a first data drain region DD1, and a second data drain region DD2.

The first data channel region DCHA1 may be a region overlapped by the first data gate electrode DG1 in the third direction DR3. The common data source region CDS may be disposed on a side of the first data channel region DCHA1, and the first data drain region DD1 may be disposed on the other side of the first data channel region DCHA1. The common data source region CDS and the first data drain region DD1 may be regions not overlapped by the first data gate electrode DG1 in the third direction DR3. The common data source region CDS and the first data drain region DD1 may be conductive regions by doping a silicon semiconductor or an oxide semiconductor with ions or impurities.

The second data channel region DCHA2 may be a region overlapped by the second data gate electrode DG2 in the third direction DR3. The common data source region CDS may be disposed on a side of the second data channel region DCHA2, and the second data drain region DD2 may be disposed on the other side of the second data channel region DCHA2. The common data source region CDS and the second data drain region DD2 may be regions not overlapped by the second data gate electrode DG2 in the third direction DR3. The common data source region CDS and the second data drain region DD2 may be conductive regions by doping a silicon semiconductor or an oxide semiconductor with ions or impurities.

The first data gate electrode DG1, the second data gate electrode DG2, and the first data fan-out line DFL1 may be disposed on the first gate insulating layer 130. The first data gate electrode DG1 may be connected to the first data distribution control line DM1 through a first data contact hole CT1. The second data gate electrode DG2 may be connected to the second data distribution control line DM2 through a second data contact hole CT2. The first data fan-out line DFL1 may be connected to the common data source region CDS through third data contact holes CT3 passing through the first gate insulating layer 130. The first data gate electrode DG1 and the first data fan-out line DFL1 may be made of the same material as the first gate electrode G1.

The third data fan-out line DFL3 may be disposed on the first interlayer insulating film 141. The third data fan-out line DFL3 does not overlap the first data fan-out line DFL1 in the third direction DR3. The third data fan-out line DFL3 may be connected to the common data source region CDS through third data contact holes CT3" passing through the first gate insulating layer 130 and the first interlayer insulating film 141. The third data fan-out line DFL3 may be made of the same material as the second capacitor electrode CAE2.

The data lines DL1 through DLp and the second data fan-out line DFL2 may be disposed on the second interlayer insulating film 142. An odd-numbered data line, for example, a first data line DL1 may be connected to the first data drain region DD1 of the data active layer DACT through fourth data contact holes CT4 passing through the first gate insulating layer 130, the first interlayer insulating film 141, and the second interlayer insulating film 142. An even-numbered data line, for example, a second data line DL2 may be connected to the second data drain region DD2 of the data active layer DACT through fifth data contact holes CT5 passing through the first gate insulating layer 130, the first interlayer insulating film 141, and the second interlayer insulating film 142. The second data fan-out line DFL2 may be connected to the common data source region CDS through third data contact holes CT3' passing through the first gate insulating layer 130, the first interlayer insulating film 141, and the second interlayer insulating film 142. The data lines DL1 through DLp and the second data fan-out line DFL2 may be made of the same material as the first anode connection electrode ANDE1.

To minimize line widths of the first through third data fan-out lines DFL1 through DFL3 in the first main non-display area MNDA1, the first auxiliary non-display area ANDA1, the second auxiliary non-display area ANDA2, and the sub-area SBA, a part of the second data fan-out line DFL2 may at least partially overlap the first data fan-out line DFL1 in the third direction DR3, and another part of the second data fan-out line DFL2 may at least partially overlap the third data fan-out line DFL3 in the third direction DR3.

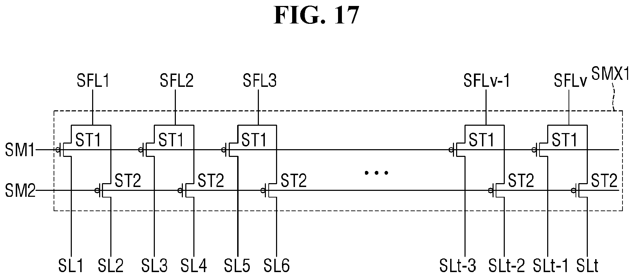

FIG 17 is a circuit diagram of a first sensor distribution circuit SMX1 according to an embodiment of the present disclosure.

Referring to FIG 17, the first sensor distribution circuit SMX1 may temporally divide sensor fan-out lines SFL1 through SFLv (where *v* is an integer of 2 or greater) and distribute the temporally divided sensor fan-out lines SFL1 through SFLv to sensor lines SL1 through SLt (where t is an integer satisfying t=2v) by using sensor distribution transistors ST1 and ST2 sequentially turned on by sensor distribution control signals supplied to sensor distribution control lines SM1 and SM2. In FIG 17, the first sensor distribution circuit SMX1 connects the sensor lines SL1 through SLt and the sensor fan-out lines SFL1 through SFLv in a 2:1 ratio to temporally divide one sensor fan-out line and connect the temporally divided sensor fan-out line to two sensor lines. However, embodiments of the present specification are not necessarily limited thereto.

The first sensor distribution circuit SMX1 may include first sensor distribution transistors ST1 and second sensor distribution transistors ST2.

First sensor gate electrodes of the first sensor distribution transistors ST1 may be commonly connected to a first sensor distribution control line SM1. Therefore, the first sensor distribution transistors ST1 may be commonly turned on or turned off according to a first sensor distribution control signal of the first sensor distribution control line SM1.

Second sensor gate electrodes of the second sensor distribution transistors ST2 may be commonly connected to a second sensor distribution control line SM2. Therefore, the second sensor distribution transistors ST2 may be commonly turned on or turned off according to a second sensor distribution control signal of the second sensor distribution control line SM2.

A first sensor distribution transistor ST1 and a second sensor distribution transistor ST2 connected to one sensor fan-out line may be connected to different sensor lines. For example, a first sensor distribution transistor ST1 connected to a first sensor fan-out line SFL1 may be connected to a first sensor line SL1, and a second sensor distribution transistor ST2 connected to the first sensor fan-out line SFL1 may be connected to a second sensor line SL2.

When the first sensor distribution control signal of a gate-on voltage is transmitted to the first sensor distribution control line SM1, the first sensor distribution transistors ST1 may be turned on. Accordingly, the sensor fan-out lines SFL1 through SFLv may be connected to odd-numbered sensor lines SL1, SL3, SL5, ..., SLt-3 and SLt-1.

When the second sensor distribution control signal of the gate-on voltage is transmitted to the second sensor distribution control line SM2, the second sensor distribution transistors ST2 may be turned on. Accordingly, the sensor fan-out lines SFL1 through SFLv may be connected to even-numbered sensor lines SL2, SL4, SL6, ..., SLt-2 and SLt.

The first sensor distribution transistors ST1 and the second sensor distribution transistors ST2 of the first sensor distribution circuit SMX1 may be formed as thin-film transistors. In addition, although the first sensor distribution transistors ST1 and the second sensor distribution transistors ST2 of the first sensor distribution circuit SMX1 are formed as p-type MOSFETs in FIG 17, embodiments of the present specification are not necessarily limited thereto. For example, the first sensor distribution transistors ST1 and the second sensor distribution transistors ST2 of the first sensor distribution circuit SMX1 may also be formed as n-type MOSFETs.

The second sensor distribution circuit SMX2 is substantially the same as the first sensor distribution circuit SMX1 described above with reference to FIG 17, and thus to the extent that an element is not described in detail herein, it may be assumed that the element is at least similar or identical to corresponding elements described elsewhere within the instant disclosure.

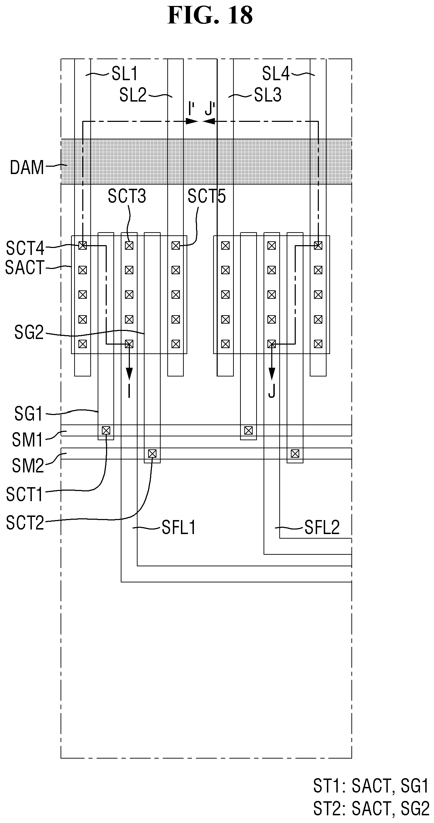

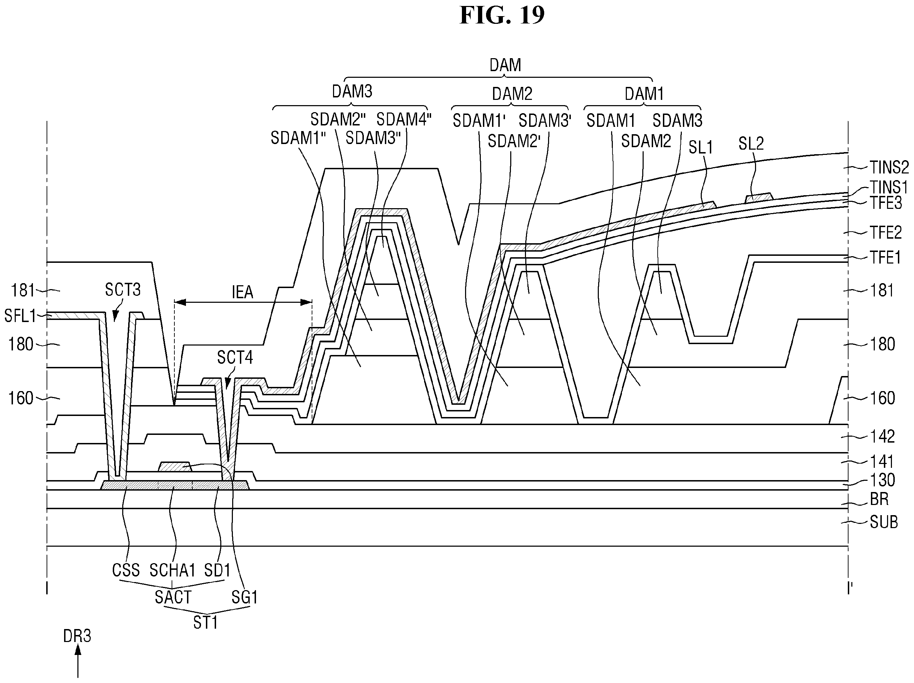

FIG 18 is a plan view illustrating a layout of an example of sensor distribution transistors connected to the first sensor fan-out line SFL1 and a second sensor fan-out line SFL2 of FIG 17. FIG 19 is a cross-sectional view of an example of the display panel 100 taken along line I-I' of FIG 18. An example of the display panel 100 taken along line J-J' of FIG 18 is substantially the same as an example of the display panel 100 taken along line I-I' of FIG 18, and thus it may be assumed that this structure is at least similar or identical to corresponding structures described herein and illustrated in the drawings.

Referring to FIGS. 18 and 19, a first sensor distribution transistor ST1 may include a sensor active layer SACT and a first sensor gate electrode SG1, and a second sensor distribution transistor ST2 may include the sensor active layer SACT and a second sensor gate electrode SG2. For example, the first sensor distribution transistor ST1 and the second sensor distribution transistor ST2 may share the sensor active layer SACT.

The sensor active layer SACT may be disposed on the barrier layer BR. The sensor active layer SACT may include polycrystalline silicon, monocrystalline silicon, low-temperature polycrystalline silicon, amorphous silicon, or an oxide semiconductor. The sensor active layer SACT may be made of the same material as the first active layer ACT1 and the data active layer DACT.

The sensor active layer SACT may include a first sensor channel region SCHA1, a second sensor channel region SCHA2, a common sensor source region CSS, a first sensor drain region SD1, and a second sensor drain region SD2.

The first sensor channel region SCHA1 may be a region overlapped by the first sensor gate electrode SG1 in the third direction DR3. The common sensor source region CSS may be disposed on a side of the first sensor channel region SCHA1, and the first sensor drain region SD1 may be disposed on the other side of the first sensor channel region SCHA1. The common sensor source region CSS and the first sensor drain region SD1 may be regions not overlapped by the first sensor gate electrode SG1 in the third direction DR3. The common sensor source region CSS and the first sensor drain region SD1 may be conductive regions by doping a silicon semiconductor or an oxide semiconductor with ions or impurities.

The second sensor channel region SCHA2 may be a region overlapped by the second sensor gate electrode SG2 in the third direction DR3. The common sensor source region CSS may be disposed on a side of the second sensor channel region SCHA2, and the second sensor drain region SD2 may be disposed on the other side of the second sensor channel region SCHA2. The common sensor source region CSS and the second sensor drain region SD2 may be regions not overlapped by the second sensor gate electrode SG2 in the third direction DR3. The common sensor source region CSS and the second sensor drain region SD2 may be conductive regions by doping a silicon semiconductor or an oxide semiconductor with ions or impurities.

The first sensor gate electrode SG1 and the second sensor gate electrode SG2 may be disposed on the first gate insulating layer 130. The first sensor gate electrode SG1 may be connected to the first sensor distribution control line SM1 through a first sensor contact hole SCT1. The second sensor gate electrode SG2 may be connected to the second sensor distribution control line SM2 through a second sensor contact hole SCT2. The first sensor gate electrode SG1 and the second sensor gate electrode SG2 may be made of the same material as the first gate electrode G1, the first data gate electrode DG1, a second gate electrode G2, the second data gate electrode DG2, and the first data fan-out line DFL1.

The first sensor fan-out line SFL1 and the second sensor fan-out line SFL2 may be disposed on the second planarization layer 180. Each of the first sensor fan-out line SFL1 and the second sensor fan-out line SFL2 may be connected to the common sensor source region CSS through third sensor contact holes SCT3 passing through the first gate insulating layer 130, the first interlayer insulating film 141, the second interlayer insulating film 142, the first planarization layer 160, and the second planarization layer 180. The first sensor fan-out line SFL1 and the second sensor fan-out line SFL2 may be made of the same material as the third anode connection electrode ANDE3.

The dam DAM may be an area in which one or more dams DAM1 through DAM3 are disposed. Although the dam DAM includes a first dam DAM1, a second dam DAM2, and a third dam DAM3 in FIG 19, the number of dams included in the dam DAM is not necessarily limited thereto.

The first dam DAM1, the second dam DAM2, and the third dam DAM3 may be spaced apart from each other. The first dam DAM1 may be disposed closest to a display area DA, and the third dam DAM3 may be disposed farthest from the display area DA. The second dam DAM2 may be disposed between the first dam DAM1 and the third dam DAM3.

Each of the first dam DAM1, the second dam DAM2, and the third dam DAM3 may include a first sub-dam SDAM1/SDAM1'/SDAM1", a second sub-dam SDAM2/SDAM2'/SDAM2" disposed on the first sub-dam SDAM1/SDAM1'/SDAM1", and a third sub-dam SDAM3/SDAM3'/SDAM3" disposed on the second sub-dam SDAM2/SDAM2'/SDAM2". The third dam DAM3 may further include a fourth sub-dam SDAM4" disposed on the third sub-dam SDAM3".

The first sub-dam SDAM1/SDAM1'/SDAM1" may include the same material as the second planarization layer 180. A thickness of the first sub-dam SDAM1/SDAM1'/SDAM1" may be substantially the same as a thickness of the second planarization layer 180.

The second sub-dam SDAM2/SDAM2'/SDAM2" may include the same material as the third planarization layer 181. A thickness of the second sub-dam SDAM2/SDAM2'/SDAM2" may be substantially the same as a thickness of the third planarization layer 181.

The third sub-dam SDAM3/SDAM3'/SDAM3" may include the same material as the bank 190. A thickness of the third sub-dam SDAM3/SDAM3'/SDAM3" may be substantially the same as a thickness of the bank 190.

The fourth sub-dam SDAM4" may include the same material as a spacer 191 disposed on the bank 190. A thickness of the fourth sub-dam SDAM4" may be substantially the same as a thickness of the spacer 191.

The first sensor line SL1 and the second sensor line SL2 may be disposed on the first sensor insulating layer TINS1. The first sensor line SL1 may be disposed on the dam DAM. The first sensor line SL1 may be connected to the first sensor drain region SD1 of the sensor active layer SACT through fourth sensor contact holes SCT4 passing through the first gate insulating layer 130, the first interlayer insulating film 141, the second interlayer insulating film 142, the first encapsulating inorganic layer TFE1, the second encapsulating inorganic layer TFE3, and the first sensor insulating layer TINS1. The second sensor line SL2 may be connected to the second sensor drain region SD2 of the sensor active layer SACT through fifth sensor contact holes SCT5 passing through the first gate insulating layer 130, the first interlayer insulating film 141, the second interlayer insulating film 142, the first encapsulating inorganic layer TFE1, the second encapsulating inorganic layer TFE3, and the first sensor insulating layer TINS1.

Thus, the sensor fan-out lines SFL1 and SFL2 may be disposed on the second planarization layer 180, and the data fan-out lines DFL1, DFL2 and DFL3 may be alternately disposed on the first gate insulating layer 130, the first interlayer insulating film 141, and the second interlayer insulating film 142. For example, the sensor fan-out lines SFL1 and SFL2 may be disposed on a different layer from the data fan-out lines DFL1, DFL2 and DFL3. Therefore, the sensor fan-out lines SFL1 and SFL2 and the data fan-out lines DFL1, DFL2 and DFL3 may be designed without interfering with each other in the sub-area SBA, the first main non-display area MNDA1, the first auxiliary non-display area ANDA1, and the second auxiliary non-display area ANDA2.

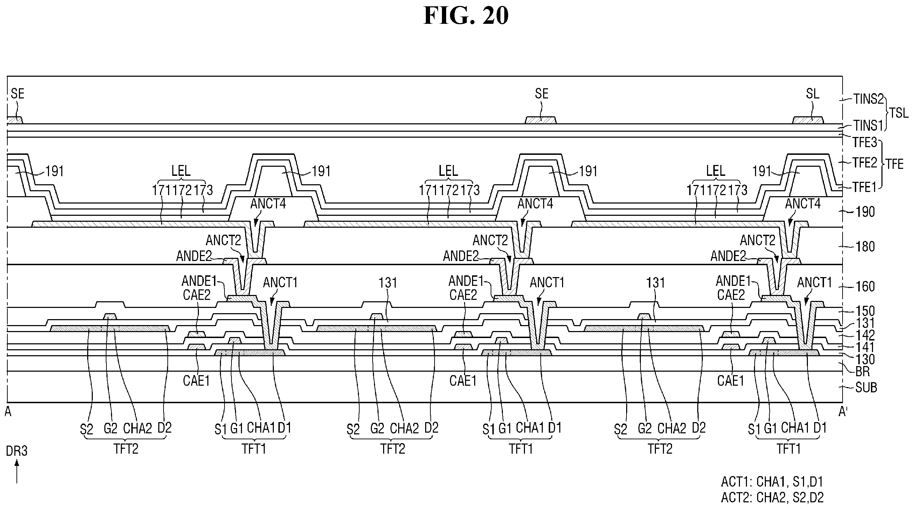

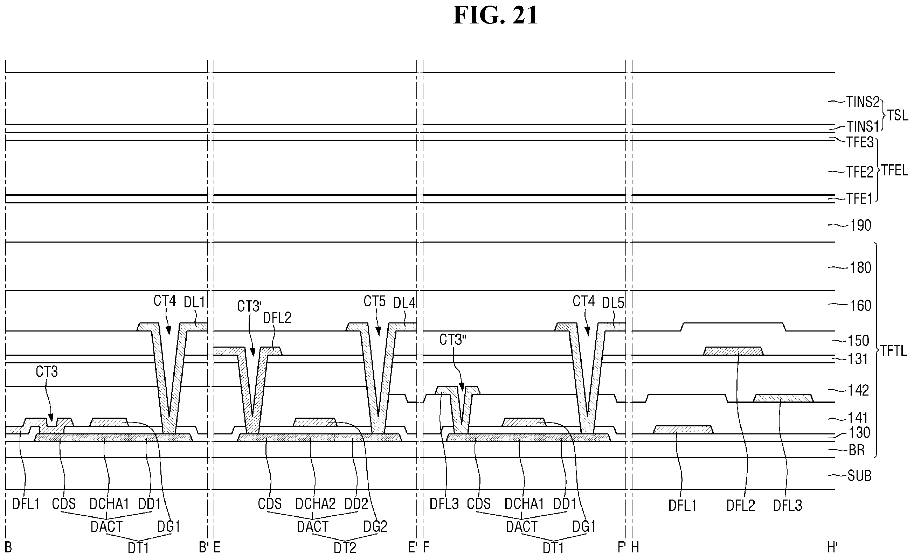

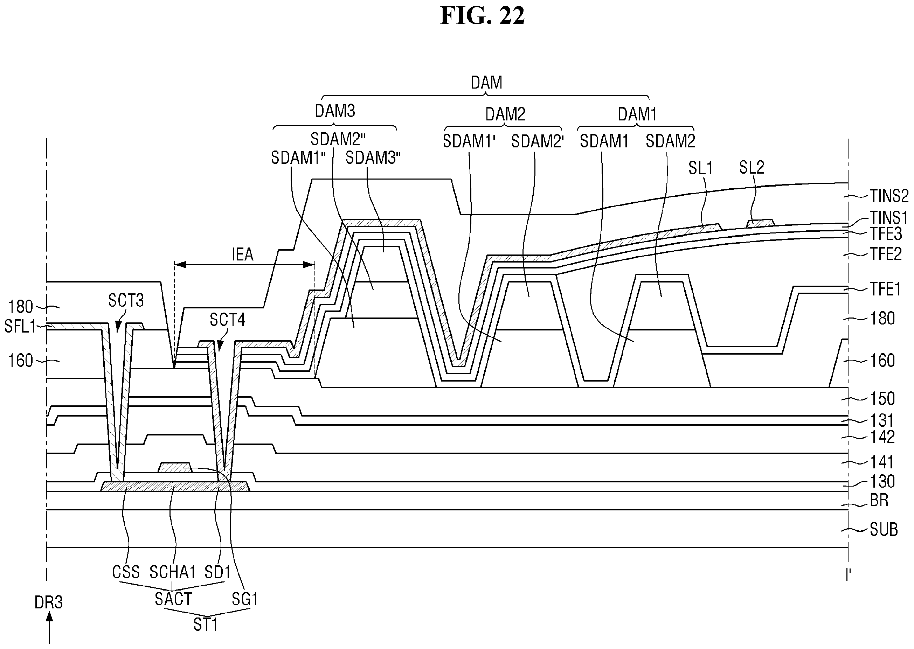

FIG 20 is a cross-sectional view of an example of the display panel 100 taken along line A-A' of FIG 12. FIG 21 is a cross-sectional view of an example of the display panel 100 taken along lines B-B', E-E', F-F', and H-H' of FIG 15. FIG 22 is a cross-sectional view of an example of the display panel 100 taken along line I-I' of FIG 18.

The embodiment of FIGS. 20 through 22 is different from the embodiment of FIGS. 13, 16 and 19 in that the display panel 100 further includes second thin-film transistors TFT2, each having a second active layer ACT2 and a second gate electrode G2, a second gate insulating layer 131 and a third interlayer insulating film 150 and does not include third anode connection electrodes ANDE3 and a third planarization layer 181. In FIGS. 20 through 22, to the extent that a detailed description of one or elements has been omitted, it may be assumed that those elements are at least similar or identical to corresponding elements that are described above with reference to FIGS. 13, 16 and 19.

Referring to FIGS. 20 through 22, the second thin-film transistors TFT2 may be disposed on a second interlayer insulating film 142. Each of the second thin-film transistors TFT2 may include the second active layer ACT2 and the second gate electrode G2.

The second active layer ACT2 of each of the second thin-film transistors TFT2 may be disposed on the second interlayer insulating film 142. The second active layer ACT2 may include an oxide semiconductor. For example, the second active layer ACT2 may include IGZO (indium (In), gallium (Ga), zinc (Zn) and oxygen (O)), IGZTO (indium (In), gallium (Ga), zinc (Zn), tin (Sn) and oxygen (O)), or IGTO (indium (In), gallium (Ga), tin (Sn) and oxygen (O)).

The second active layer ACT2 may include a second channel region CHA2, a second source region S2, and a second drain region D2. The second channel region CHA2 may be a region overlapped by the second gate electrode G2 in the third direction DR3. The second source region S2 may be disposed on a side of the second channel region CHA2, and the second drain region D2 may be disposed on the other side of the second channel region CHA2. The second source region S2 and the second drain region D2 may be regions not overlapped by the second gate electrode G2 in the third direction DR3. The second source region S2 and the second drain region D2 may be conductive regions by doping a silicon semiconductor or an oxide semiconductor with ions or impurities.

The second gate insulating layer 131 may be disposed on the second active layers ACT2 of the second thin-film transistors TFT2. The second gate insulating layer 131 may be made of an inorganic layer such as a silicon nitride layer, a silicon oxynitride layer, a silicon oxide layer, a titanium oxide layer, or an aluminum oxide layer.

The second gate electrodes G2 of the second thin-film transistors TFT2 and a second data fan-out line DFL2 may be disposed on the second gate insulating layer 131. The second gate electrodes G2 may at least partially overlap the second active layers ACT2 in the third direction DR3. The second data fan-out line DFL2 may be connected to a common data source region CDS of a data active layer DACT of a second data distribution transistor DT2 through contact holes passing through a first gate insulating layer 130, a first interlayer insulating film 141, the second interlayer insulating film 142, and the second gate insulating layer 131. Each of the second gate electrodes G2 and the second data fan-out line DFL2 may be a single layer or a multilayer structure made of any one or more of molybdenum (Mo), aluminum (Al), chromium (Cr), gold (Au), titanium (Ti), nickel (Ni), neodymium (Nd), copper (Cu), and alloys of the same.

The third interlayer insulating film 150 may be disposed on the second gate electrodes G2 of the second thin-film transistors TFT2. The third interlayer insulating film 150 may be made of an inorganic layer such as a silicon nitride layer, a silicon oxynitride layer, a silicon oxide layer, a titanium oxide layer, or an aluminum oxide layer. The third interlayer insulating film 150 may be composed of a plurality of inorganic layers.

First anode connection electrodes ANDE1 and data lines DL1 through DLp may be disposed on the third interlayer insulating film 150. A first planarization layer 160 may be disposed on the first anode connection electrodes ANDE1 and the data lines DL1 through DLp.

Each of a first dam DAM1, a second dam DAM2, and a third dam DAM3 may include a first sub-dam SDAM1/SDAM1'/SDAM1" and a second sub-dam SDAM2/SDAM2'/SDAM2" disposed on the first sub-dam SDAM1/SDAM1'/SDAM1". The third dam DAM3 may further include a third sub-dam SDAM3" disposed on the second sub-dam SDAM2".

The first sub-dam SDAM1/SDAM1'/SDAM1" may include the same material as a second planarization layer 180. A thickness of the first sub-dam SDAM1/SDAM1'/SDAM1" may be substantially the same as a thickness of the second planarization layer 180.

The second sub-dam SDAM2/SDAM2'/SDAM2" may include the same material as a bank 190. A thickness of the second sub-dam SDAM2/SDAM2'/SDAM2" may be substantially the same as a thickness of the bank 190.

The third sub-dam SDAM3" may include the same material as a spacer 191 disposed on the bank 190. A thickness of the third sub-dam SDAM3" may be substantially the same as a thickness of the spacer 191.

A first sensor fan-out line SFL1 and a second sensor fan-out line SFL2 may be disposed on the first planarization layer 160. Each of the first sensor fan-out line SFL1 and the second sensor fan-out line SFL2 may be connected to a common sensor source region CSS through third sensor contact holes SCT3 passing through the first gate insulating layer 130, the first interlayer insulating film 141, the second interlayer insulating film 142, and the first planarization layer 160. The first sensor fan-out line SFL1 and the second sensor fan-out line SFL2 may be made of the same material the first anode connection electrodes ANDE1 and the data lines DL1 through DLp.

The second planarization layer 180 may be disposed on the first sensor fan-out line SFL1 and the second sensor fan-out line SFL2. Light emitting elements LEL and the bank 190 may be disposed on the second planarization layer 180.

A first sensor line SL1 may be connected to a first sensor drain region SD1 of a sensor active layer SACT of a first sensor distribution transistor ST1 through fourth sensor contact holes SCT4 passing through the first gate insulating layer 130, the first interlayer insulating film 141, the second interlayer insulating film 142, the second gate insulating layer 131, the third interlayer insulating film 150, a first encapsulating inorganic layer TFE1, a second encapsulating inorganic layer TFE3, and a first sensor insulating layer TINS 1. A second sensor line SL2 may be connected to a second sensor drain region SD2 of the sensor active layer SACT through fifth sensor contact holes SCT5 passing through the first gate insulating layer 130, the first interlayer insulating film 141, the second interlayer insulating film 142, the second gate insulating layer 131, the third interlayer insulating film 150, the first encapsulating inorganic layer TFE1, the second encapsulating inorganic layer TFE3, and the first sensor insulating layer TINS1.

Thus, the sensor fan-out lines SFL1 and SFL2 may be disposed on the first planarization layer 160, and the data fan-out lines DFL1, DFL2 and DFL3 may be alternately disposed on the first gate insulating layer 130, the first interlayer insulating film 141, and the second gate insulating layer 131. For example, the sensor fan-out lines SFL1 and SFL2 may be disposed on a different layer from the data fan-out lines DFL1, DFL2 and DFL3. Therefore, the sensor fan-out lines SFL1 and SFL2 and the data fan-out lines DFL1, DFL2 and DFL3 may be designed without interfering with each other in a sub-area SBA, a first main non-display area MNDA1, a first auxiliary non-display area ANDA1, and a second auxiliary non-display area ANDA2.

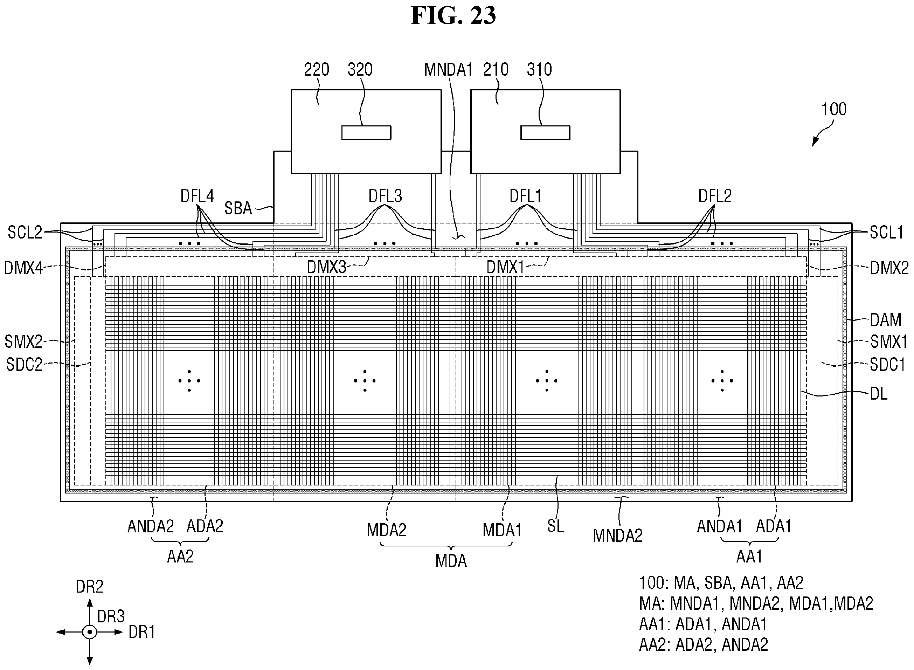

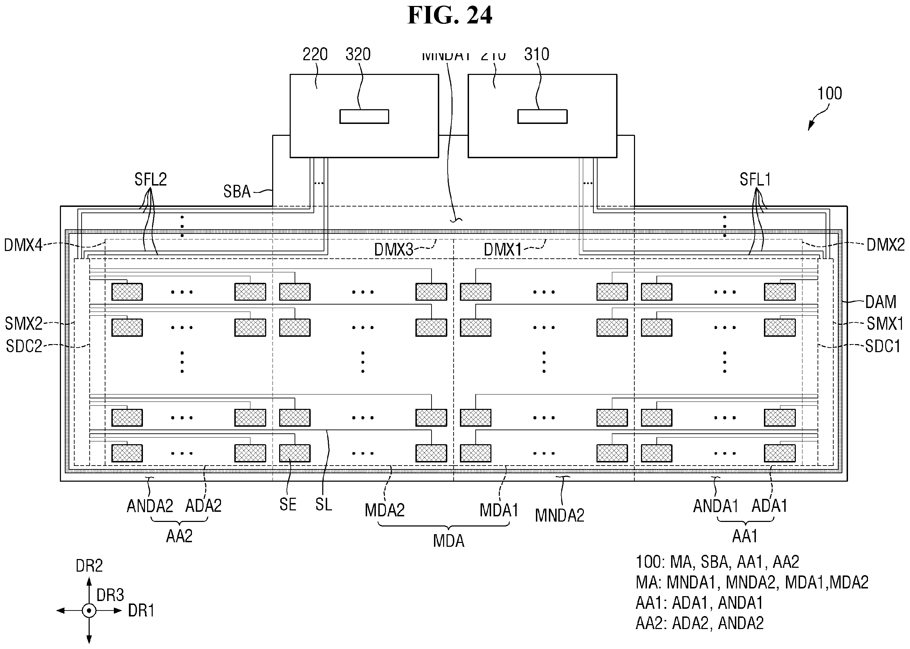

FIG 23 is a plan view illustrating a layout of scan lines SCAL, data lines DL, a first scan driver SDC1, a second scan driver SDC2, data distribution circuits, a first sensor distribution circuit SMX1, and a second sensor distribution circuit SMX2 of a display layer DISL of a display panel 100 according to an embodiment of the present disclosure. FIG 24 is a plan view illustrating a layout of sensor electrodes SE and sensor lines SL of a touch sensing layer TSL of the display panel 100 according to the embodiment.

The embodiment of FIGS. 23 and 24 is different from the embodiment of FIGS. 10 and 11 in that a dam DAM surrounds upper, right and lower sides of the first sensor distribution circuit SMX1 and upper, left and lower sides of the second sensor distribution circuit SMX2. In FIGS. 23 and 24, to the extent that a detailed description of one or elements has been omitted, it may be assumed that those elements are at least similar or identical to corresponding elements that are described above with reference to FIGS. 10 and 11.

Referring to FIGS. 23 and 24, the dam DAM may at least partially surround upper and lower sides of a main display area MDA, upper and lower sides of a first auxiliary non-display area ANDA1, upper and lower sides of a second auxiliary non-display area ANDA2, upper and lower sides of the first scan driver SDC1, upper and lower sides of the second scan driver SDC2, the upper, right and lower sides of the first sensor distribution circuit SMX1, and the upper, left and lower sides of the second sensor distribution circuit SMX2.

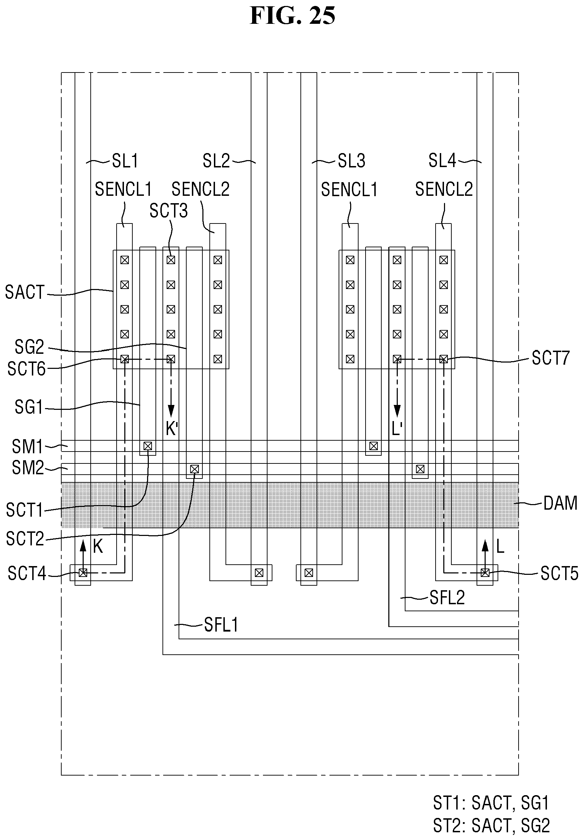

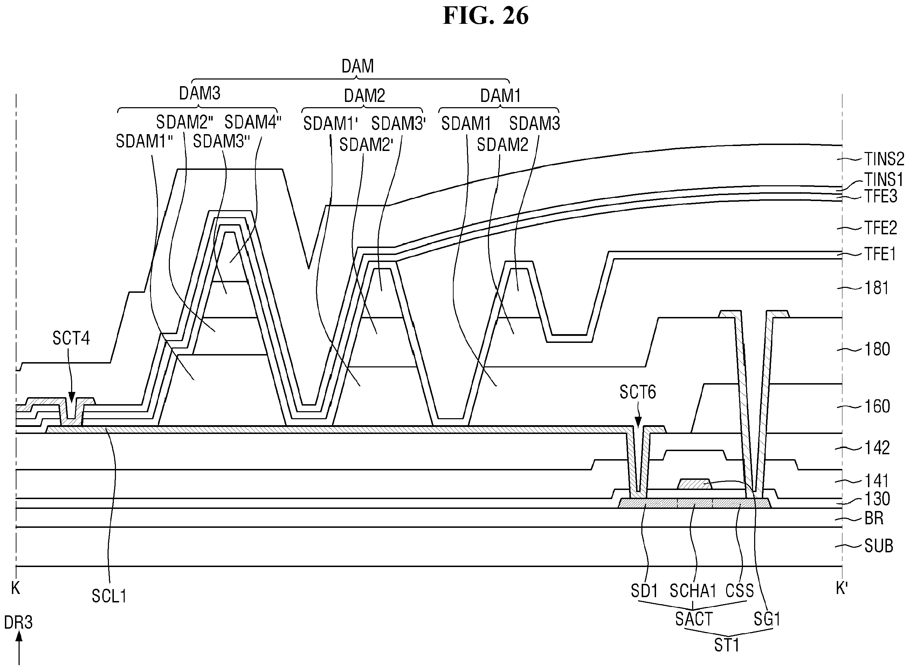

FIG 25 is a plan view illustrating a layout of an example of sensor distribution transistors connected to a first sensor fan-out line SFL1 and a second sensor fan-out line SFL2 of FIG 24. FIG 26 is a cross-sectional view of an example of the display panel 100 taken along line K-K' of FIG 25. An example of the display panel 100 taken along line L-L' of FIG 25 is substantially the same as an example of the display panel 100 taken along line K-K' of FIG 25, and thus it may be assumed that this structure is at least similar or identical to corresponding structures described herein and illustrated in the drawings.

The embodiment of FIGS. 25 and 26 is different from the embodiment of FIGS. 18 and 19 in that a first sensor connection line SCL1 connecting a first sensor line SL1 and a first sensor drain region SD1 of a sensor active layer SACT is added, and a second sensor connection line SCL2 connecting a second sensor line SL2 and a second sensor drain region SD2 of the sensor active layer SACT is added. In FIGS. 25 and 26, to the extent that a detailed description of one or elements has been omitted, it may be assumed that those elements are at least similar or identical to corresponding elements that are described above with reference to FIGS. 18 and 19.

Referring to FIGS. 25 and 26, each of sensor lines SL1 through SL4 may at least partially overlap the dam DAM. Each of the sensor lines SL1 through SL4 may be disposed on a first dam DAM1, a second dam DAM2, and a third dam DAM3.

Each of sensor connection lines SCL1 through SCL4 may at least partially overlap the dam DAM The first dam DAM1, the second dam DAM2, and the third dam DAM3 may be disposed on the sensor connection lines SCL1 through SCL4.

The first sensor connection line SCL1 and the second sensor connection line SCL2 may be disposed on a second interlayer insulating film 142. In this case, the first sensor line SL1 may be connected to the first sensor connection line SCL1 through a fourth sensor contact hole SCT4 passing through a first encapsulating inorganic layer TFE1, a second encapsulating inorganic layer TFE3, and a first sensor insulating layer TINS1. The first sensor connection line SCL1 may be connected to the first sensor drain region SD1 of the sensor active layer SACT through sixth sensor contact holes SCT6 passing through a first gate insulating layer 130, a first interlayer insulating film 141, and the second interlayer insulating film 142. In addition, the second sensor line SL2 may be connected to the second sensor connection line SCL2 through a fifth sensor contact hole SCT5 passing through the first encapsulating inorganic layer TFE1, the second encapsulating inorganic layer TFE3, and the first sensor insulating layer TINS1. The second sensor connection line SCL2 may be connected to the second sensor drain region SD2 of the sensor active layer SACT through seventh sensor contact holes SCT7 passing through the first gate insulating layer 130, the first interlayer insulating film 141, and the second interlayer insulating film 142.

Alternatively, the first sensor connection line SCL1 and the second sensor connection line SCL2 may be disposed on the first interlayer insulating film 141. In this case, the first sensor line SL1 may be connected to the first sensor connection line SCL1 through a fourth sensor contact hole SCT4 passing through the second interlayer insulating film 142, the first encapsulating inorganic layer TFE1, the second encapsulating inorganic layer TFE3, and the first sensor insulating layer TINS1. The first sensor connection line SCL1 may be connected to the first sensor drain region SD1 of the sensor active layer SACT through sixth sensor contact holes SCT6 passing through the first gate insulating layer 130 and the first interlayer insulating film 141. In addition, the second sensor line SL2 may be connected to the second sensor connection line SCL2 through a fifth sensor contact hole SCT5 passing through the second interlayer insulating film 142, the first encapsulating inorganic layer TFE1, the second encapsulating inorganic layer TFE3, and the first sensor insulating layer TINS1. The second sensor connection line SCL2 may be connected to the second sensor drain region SD2 of the sensor active layer SACT through seventh sensor contact holes SCT7 passing through the first gate insulating layer 130 and the first interlayer insulating film 141.

Alternatively, the first sensor connection line SCL1 and the second sensor connection line SCL2 may be disposed on the first gate insulating layer 130. In this case, the first sensor line SL1 may be connected to the first sensor connection line SCL1 through a fourth sensor contact hole SCT4 passing through the first interlayer insulating film 141, the second interlayer insulating film 142, the first encapsulating inorganic layer TFE1, the second encapsulating inorganic layer TFE3, and the first sensor insulating layer TINS1. The first sensor connection line SCL1 may be connected to the first sensor drain region SD1 of the sensor active layer SACT through sixth sensor contact holes SCT6 passing through the first gate insulating layer 130. In addition, the second sensor line SL2 may be connected to the second sensor connection line SCL2 through a fifth sensor contact hole SCT5 passing through the first interlayer insulating film 141, the second interlayer insulating film 142, the first encapsulating inorganic layer TFE1, the second encapsulating inorganic layer TFE3, and the first sensor insulating layer TINS 1. The second sensor connection line SCL2 may be connected to the second sensor drain region SD2 of the sensor active layer SACT through seventh sensor contact holes SCT7 passing through the first gate insulating layer 130.

As illustrated in FIGS. 25 and 26, when the dam DAM is disposed outside the first sensor distribution circuit SMX1 and the second sensor distribution circuit SMX2, an inorganic encapsulation area IEA for encapsulating the main display area MDA, a first auxiliary display area ADA1, and a second auxiliary display area ADA2 may be disposed outside the dam DAM. In this case, if the fourth sensor contact hole SCT4 for connecting the first sensor line SL1 to the first sensor drain region SD1 of the sensor active layer SACT is formed in the first sensor distribution circuit SMX1 and the second sensor distribution circuit SMX2, the encapsulation structure may be broken. In addition, if the fifth sensor contact hole SCT5 for connecting the second sensor line SL2 to the second sensor drain region SD2 of the sensor active layer SACT is formed in the first sensor distribution circuit SMX1 and the second sensor distribution circuit SMX2, the encapsulation structure may be broken. When the encapsulation structure is broken, moisture or oxygen may be introduced into light emitting layers 172 of the main display area MDA, the first auxiliary display area ADA1, and the second auxiliary display area ADA2.

Therefore, to prevent the encapsulation structure from being broken, the fourth sensor contact hole SCT4 is formed in the inorganic encapsulation area IEA to connect the first sensor line SL1 to the first sensor connection line SCL1, and the fifth contact hole SCT5 is formed to connect the second sensor line SL2 to the second sensor connection line SCL2 after the second sensor line SL2 is formed. Then, the first sensor connection line SCL1 is extended to the first sensor distribution circuit SMX1 and the second sensor distribution circuit SMX2 and connected to the first sensor drain region SD1 of the sensor active layer SACT through the sixth sensor contact holes SCT6. In addition, the second sensor connection line SCL2 is extended to the first sensor distribution circuit SMX1 and the second sensor distribution circuit SMX2 and connected to the second sensor drain region SD2 of the sensor active layer SACT through the seventh sensor contact holes SCT7.

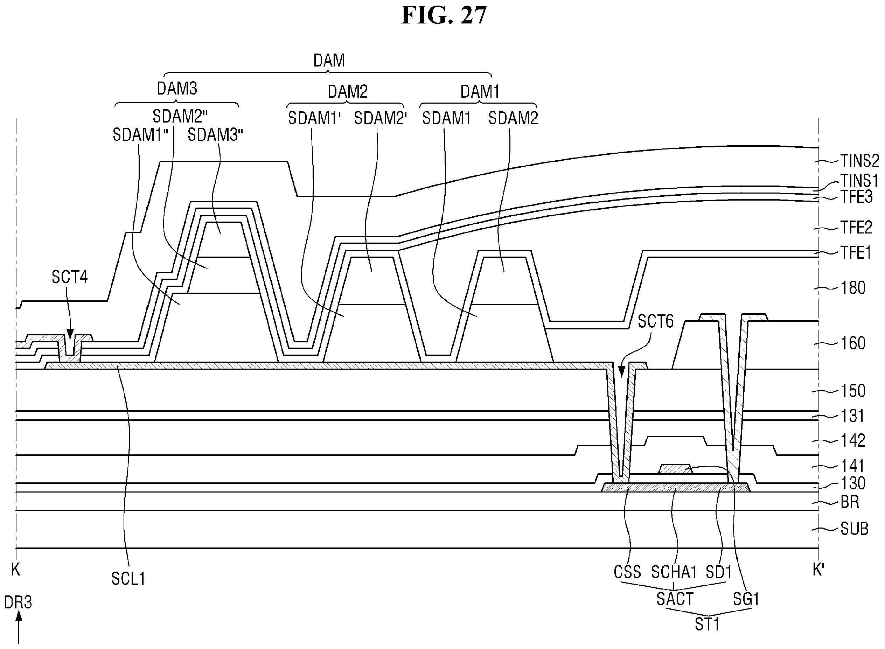

FIG 27 is a cross-sectional view of an example of the display panel 100 taken along line K-K' of FIG 25.

The embodiment of FIG 27 is different from the embodiment of FIG 26 only in that it further includes a second gate insulating layer 131 and a third interlayer insulating film 150. Thus, to the extent that a detailed description of one or elements has been omitted, it may be assumed that those elements are at least similar or identical to corresponding elements that have been described elsewhere within the instant specification.

In a display device according to embodiments of the present disclosure, a first auxiliary area and a second auxiliary area slide according to the movement of a first roller and a second roller. Accordingly, the size of a display panel seen from the front of the display device, for example, the size of a display area in which an image is displayed may be adjusted. Therefore, a user can select the size of the display panel by adjusting the display device to a first state or a second state according to the intended use of the display device.

In a display device according to embodiments of the present disclosure, sensor distribution circuits may be disposed on a right side of a first auxiliary non-display area and a left side of a second auxiliary non-display area. Therefore, it is possible to prevent a space for data distribution circuits in a first main non-display area, the first auxiliary non-display area and the second auxiliary non-display area adjacent to a sub-area from being reduced due to the sensor distribution circuits.

In a display device according to embodiments of the present disclosure, sensor fan-out lines may be disposed on a different layer from data fan-out lines. Therefore, the sensor fan-out lines and the data fan-out lines may be designed without interfering with each other in a sub-area, a first main non-display area, a first auxiliary non-display area, and a second auxiliary non-display area.

## Claims

1. A display device (10), comprising:
a substrate (SUB) comprising a main area (MA), a first auxiliary area (AA1) extending from a first side of the main area (MA) in a first direction (DR1), and a sub-area (SBA) extending from a second side of the main area (MA) in a second direction (DR2) intersecting the first direction (DR1);
scan lines (SCAL) disposed in the main area (MA) and the first auxiliary area (AA1), each of the scan lines (SCAL) extending in the first direction (DR1);
data lines (DL) disposed in the main area (MA) and the first auxiliary area (AA1), each of the data lines (DL) extending in the second direction (DR2);
sensor lines (SL) disposed in the main area (MA) and the first auxiliary area (AA1), each of the sensor lines (SL) extending in the first direction (DR1); and
sensor electrodes (SE) disposed in the main area (MA) and the first auxiliary area (AA1), each of the sensor electrodes (SE) connected to each of the sensor lines (SL), respectively.

2. The display device (10) of claim 1, further comprising:
a first scan driver (SDC1) disposed on a first edge of the first auxiliary area (AA1), the first scan driver (SDC1) connected to the scan lines (SCAL);
a first sensor distribution circuit (SMX1) disposed on the first edge of the first auxiliary area (AA1), the first sensor distribution circuit (SMX1) connected to the sensor lines (SL); and
a data distribution circuit (DMX1, DMX2) disposed on a second edge of the main area (MA) and a second edge of the first auxiliary area (AA1), the data distribution circuit (DMX1, DMX2) connected to the data lines (DL).

3. The display device (10) of claim 2, further comprising sensor fan-out lines (SFL1) connected to the first sensor distribution circuit (SMX1) and disposed on the second edge of the main area (MA), the second edge of the first auxiliary area (AA1), and the sub-area (SBA).

4. The display device (10) of claim 3, wherein a number of the sensor fan-out lines (SFL1) is smaller than a number of the sensor lines (SL).

5. The display device (10) of claim 3 or 4, wherein the first sensor distribution circuit (SMX1) comprises a sensor distribution transistor (ST1) connecting the sensor lines (SL) to the sensor fan-out lines (SFL1) in an N: 1 ratio, where N is an integer of 2 or greater.

6. The display device (10) of at least one of claims 3 to 5, further comprising data fan-out lines (DFL1, DFL2) connected to the data distribution circuit (DMX1, DMX2) and disposed on the second edge of the main area (MA), the second edge of the first auxiliary area (AA1), and the sub-area (SBA).

7. The display device (10) of claim 6, wherein a number of the data fan-out lines (DFL1, DFL2) is smaller than a number of the data lines (DL).

8. The display device (10) of claim 6 or 7, wherein the data distribution circuit (DMX1, DMX2) connects the data lines (DL) to the data fan-out lines (DFL1, DFL2) in an M: 1 ratio, where M is an integer of 2 or greater.

9. The display device (10) of at least one of claims 1 to 8, further comprising pixels disposed in the main area (MA) and the first auxiliary area (AA1), each of the pixels comprising a plurality of emission units (EA1-EA4), wherein the sensor lines (SL) do not overlap any of the plurality of emission units (EA1-EA4).

10. The display device (10) of claim 9, wherein each of the pixels comprises:
a first emission unit (EA1), of the plurality of emission units (EA1-EA4), emitting light of a first color;
a second emission unit (EA2), of the plurality of emission units (EA1-EA4), emitting light of a second color and disposed on a first side of the first emission unit (EA1) in the first direction (DR1); and
a third emission unit (EA3), of the plurality of emission units (EA1-EA4), emitting light of a third color and disposed on a second side of the first emission unit (EA1) in the second direction (DR2) intersecting the first direction (DR1) and a side of the second emission unit (EA2) in the second direction (DR2).

11. The display device (10) of claim 10, wherein one of the sensor lines (SL) is disposed between the first emission unit (EA1) and the third emission unit (EA3) and between the second emission unit (EA2) and the third emission unit (EA3).

12. The display device (10) of at least one of claims 3 to 11, further comprising a dam (DAM) disposed between the first scan driver (SDC1) and the first sensor distribution circuit (SMX1), wherein one or more of the sensor lines (SL) at least partially overlap the dam (DAM) and are connected to the sensor distribution transistor (ST1).

13. The display device (10) of at least one of claims 3 to 11, further comprising a dam (DAM) disposed outside of the first sensor distribution circuit (SMX1), wherein one or more of the sensor lines (SL) at least partially overlap the dam (DAM).

14. The display device (10) of claim 13, further comprising a sensor connection line (SLC1) connected to one of the sensor lines (SL), wherein the sensor connection line (SLC1) at least partially overlaps the dam (DAM) and is connected to the sensor distribution transistor (ST1).

15. The display device (10) of at least one of claims 1 to 14, wherein the first auxiliary area (AA1) has a curved shape, a part of the first auxiliary area (AA1) is disposed under the main area (MA), the sub-area (SBA) has a curved shape, a part of the sub-area (SBA) is disposed under the main area (MA), and the curved shape of the first auxiliary area (AA1) is smaller than the curved shape of the sub-area (SBA).

16. The display device (10) of at least one of claims 1 to 15, further comprising a first roller (410) at least partially surrounded by at least a part of the first auxiliary area (AA1) of the substrate (SUB), wherein the position of a first bending area (BA1) of the first auxiliary area (AA1) is moved in the first direction (DR1) by movement of the first roller (410), and the first auxiliary area (AA1) at least partially overlaps the main area (MA) in a first state and does not overlap the main area (MA) in a second state.
